Europäisches Patentamt

European Patent Office (11) Numéro de publication: **0 058 108**

Office européen des brevets **B1**

(12) **FASCICULE DE BREVET EUROPEEN**

(45) Date de publication du fascicule du brevet: **19.06.85**

(21) Numéro de dépôt: **82400125.9**

(22) Date de dépôt: **22.01.82**

(51) Int. Cl.⁴: **G 06 F 11/26,** H 03 K 5/15, G 06 F 7/00

(54) Générateur de signaux logiques combinés.

(30) Priorité: **26.01.81 FR 8101392**

(43) Date de publication de la demande: **18.08.82 Bulletin 82/33**

(45) Mention de la délivrance du brevet: **19.06.85 Bulletin 85/25**

(84) Etats contractants désignés: **BE DE GB IT LU NL SE**

(56) Documents cités:
DE-A-1 499 282
US-A-3 371 320

THE COMPUTER JOURNAL, vol. 6, no. 3, octobre 1963, LONDRES (GB), B.R. HEAP "Permutations by interchanges", pages 293-294

(73) Titulaire: **COMMISSARIAT A L'ENERGIE ATOMIQUE Etablissement de Caractère Scientifique Technique et Industriel 31/33, rue de la Fédération F-75015 Paris (FR)**

(72) Inventeur: **Laviron, André 15, rue des Champs Viaux Daix F-21121 Fontaine les Dijon (FR)** Inventeur: **Berard, Claude 27, Rue de Beauregard Marcilly/Tille F-21120 Is Sur Tille (FR)**

(74) Mandataire: **Mongrédien, André et al c/o BREVATOME 25, rue de Ponthieu F-75008 Paris (FR)**

## Description

La présente invention concerne un générateur de signaux logiques combinés. Ce générateur permet de former toutes les combinaisons ou un certain nombre de combinaisons de p signaux logiques à un niveau 1 et de N-p signaux logiques à un niveau 0 parmi les N sorties (QP1, QP2...QPN) que comporte ce générateur (N et p sont des constantes).

Ce générateur s'applique, par exemple, à l'étude des conséquences de défaillance de composants entrant dans les systèmes de sécurité des centrales nucléaires en réalisant, en association avec un simulateur logique, les combinaisons des défaillances des divers composants; dans cette application où l'on veut pouvoir décrire les combinaisons de composants défaillants qui entrainent la défaillance d'un système global, on simule chaque composant du système par des portes logiques, chacune de ces portes étant reliée à l'une des sorties QP1...QPN. Suivant l'état du moyen Pi, la porte correspondante simule l'état passant ou non (bon état ou défaillant) du composant du système. Pour chacune des combinaisons générée sur les moyens P, la réponse du simulateur est analysée afin de savoir s'il s'agit d'une combinaison entraînant défaillance ou non du système global. La liste de ces combinaisons est un résultat qui permet ensuite d'analyser le système global pour des études de fiabilité.

Il est évident cependant que le générateur peut s'appliquer à la simulation de tous les systèmes logiques fonctionnant à partir de la réception de signaux logiques de niveau 0 ou 1 reçus sur leurs entrées. Il est bien évident également que ce générateur peut fournir des combinaisons de p signaux logiques à un niveau 0 et de N−p signaux logiques de niveau 1, parmi les N sorties qu'il comporte.

On connaît un système qui permet d'obtenir, parmi les N sorties qu'il comporte, toutes les combinaisons de p sorties sur lesquelles sont disponibles des signaux logiques de niveau 1, les N−p sorties restantes fournissant des signaux logiques de niveau 0. Ce système comprend un compteur binaire à N sorties sur lesquelles on effectue un balayage de toutes les combinaisons possibles de ces sorties ou d'un certain nombre de ces combinaisons; cependant, sauf pour les faibles valeurs de N, le nombre de combinaisons total à balayer est en général très grand. De plus les combinaisons, n'ayant que *p* niveaux 1, p étant choisi, sont élaborées parmi d'autres combinaisons qui ne correspondent pas à ce nombre *p* de niveaux 1. Il est nécessaire, pour des questions de temps et de coût, de se limiter au balayage des premières combinaisons une par une, deux par deux, et p par p, sur les sorties du compteur. Généralement, ces combinaisons ne sont obtenues qu'à partir de systèmes lents, limités à des valeurs de p faibles, ces systèmes étant pilotés par ordinateurs.

Dans le cas des études de fiabilité de systèmes logiques, on recherche la liste des éléments défaillants qui entrainent une défaillance totale du système. La simulation des systèmes logiques est donc, dans l'état actuel de la technique, une opération compliquée, longue et coûteuse.

Le système connu décrit plus haut, comporte un compteur binaire à N bascules ($P_1$, $P_2$...$P_N$) et fonctionne de la manière suivante: Le poids le plus faible des valeurs binaires contenues dans les bascules est supposé être le poids de la valeur binaire contenue dans la bascule de rang 1 tandis que le poids le plus fort de ces valeurs binaires, est supposé être le poids de la valeur binaire contenue dans la bascule de rang N; on obtient ainsi $2^N$ combinaisons qui sont toutes les combinaisons possibles qui existent en mettant des niveaux 1 et des niveaux 0 sur les N bascules. A l'initialisation, toutes les bascules du compteur binaire sont remises à zéro. Ces bascules sont bien entendu reliées à une horloge qui leur fournit des impulsions; à la première impulsion d'horloge, la bascule $P_1$ de rang 1 passe au niveau logique 1. Ce basculement de la bascule $P_1$ fournit donc deux possibilités de comptage, en association avec la bascule $P_2$ qui est au niveau logique 0, toutes les autres bascules du compteur étant également au niveau logique 0. Le comptage se poursuit en mettant la bascule $P_2$ au niveau logique 1 et en recommençant à balayer les diverses possibilités offertes par la bascule $P_1$ qui peut être, soit au niveau logique 0, soit au niveau logique 1. La bascule $P_2$ fournit ainsi deux possibilités de choix (niveau logique 0, ou niveau logique 1) qui, associées au niveau logique de la bascule $P_1$, donnent deux nouvelles possibilités, soit au total $2 \times 2 = 4$ combinaisons. Ainsi, de proche en proche, chaque fois que toutes les combinaisons sont balayées, la bascule de poids directement supérieure est mise à 1, tandis que toutes les bascules de poids inférieur sont réinitialisées à zéro. Il résulte de ces observations, que, grâce à un compteur binaire dont on balaye les sorties, il est possible d'obtenir $2^N$ combinaisons.

Cependant, le nombre total de combinaisons à balayer est très grand lorsque N présente une valeur importante.

L'invention a pour but de remédier à ces inconvénients et notamment de réaliser un générateur de signaux logiques combinés dans lequel la recherche d'une combinaison de signaux n'exige pas l'utilisation d'un ordinateur effectuant un balayage compliqué, long et coûteux des signaux de sortie de ce générateur.

L'invention a pour objet un générateur de signaux logiques combinés pour former des combinaisons de p sorties au niveau logique 1 et N−p sorties au niveau logique 0 parmi N sorties (QP1,...QPN) du générateur sur lesquelles sont disponibles les p signaux logiques de niveau 1 et les N−p signaux logiques de niveau 0, N et p étant des constantes, caractérisé en ce qu'il comprend:

— un ensemble (P) de N moyens de mémorisation (P1, P2,...PN), ces moyens de mémorisation étant repérés du rang 1 au rang N, les combinaisons des p sorties au niveau 1 et N−p sorties au niveau 0 étant fournies sur les sorties (QP1,...QPN) de ces moyens de mémorisation de rangs 1 à N;

— des moyens CH pour charger dans les moyens de mémorisation (P1, P2,...PN), les niveaux logiques correspondant à une combinaison prédéterminée de départ;

— des moyens de commande M pour repérer le moyen de mémorisation Pi qui est défini comme étant un moyen dont la sortie est au niveau logique 1 et qui est immédiatement suivi par le moyen de mémorisation $P_{i+1}$ dont la sortie est au niveau logique 0, le rang i étant le plus faible possible, les moyens M permettant de ramener, sur tous les moyens de mémorisation qui précèdent éventuellement le moyen $P_i$, une succession de niveaux logiques 1, en commençant par le moyen de mémorisation de rang 1 jusqu'au moyen de rang n inclus, n étant égal au nombre de niveaux 1 existant sur les moyens de mémorisation précédant le moyen Pi, succession complétée éventuellement de niveaux 0 après le moyen de mémorisation de rang n et avant le moyen de rang i, les moyens de commande M permettant aussi de remplacer l'état du moyen de mémorisation Pi par un niveau 0 et l'état du moyen de mémorisation Pi+1 par un niveau 1, les moyens de mémorisation de rang supérieur à i+1 ne changeant pas d'état, l'application répétée du moyen de commande M fournissant les combinaisons qui suivent la combinaison particulière;

— des moyens A pour arrêter la génération des combinaisons après une ature combinaison prédéterminée.

Selon un mode de réalisation particulier de l'invention, ladite combinaison prédéterminée de départ est, soit la première combinaison pour laquelle les niveaux logiques 1 sont disponibles sur les sorties des p premiers moyens de mémorisation (P1, P2...Pp), les sorties des N−p moyens de mémorisation suivants (Pp+1, Pp+2...PN) étant au niveau logique 0, soit toute autre combinaison prédéterminée disponible sur les sorties de *p* moyens de mémorisation.

Selon un autre mode de réalisation particulier les moyens de commande M comprennent:

— des moyens R pour repérer le rang t d'un certain moyen de mémorisation Pt et faire évoluer le rang t, ces moyens R étant reliés aux moyens de chargement CH pour initialiser t à une valeur telle que le moyen de mémorisation Pt correspondant soit celui qui suit le premier moyen de mémorisation dont la sortie est au niveau logique 1, lorsque la combinaison est disponible sur les sorties QP1 à QPN;

— un moyen de mémorisation PO dont la sortie est QPO;

— des moyens U pour provoquer une succession d'une ou plusieurs opérations de décalages entre les moyens de mémorisation de l'ensemble P, jusqu'à ce que l'état de la sortie QPO du moyen de mémorisation PO, soit au niveau 0, chaque opération réalisant des décalages simultanés de l'état du moyen de mémorisation PO, vers le moyen de mémorisation P1 et de chacun des moyens Pj de rang j, vers le moyen suivant Pj+1 de rang j+1, pour tous les moyens Pj dont le rang est compris entre 1 et t−1, les moyens Pk de rang k ne changeant pas d'état pour tous les moyens de mémorisation Pk de rang k supérieur à t, le moyen de mémorisation PO étant chargé par l'état de la sortie du moyen Pt de rang t, au cours de cette opération de décalage, chaque opération provoquant aussi, soit une réinitialisation de la limite t des moyens de repérage et d'initialisation R, à condition que la sortie du moyen de mémorisation Pt, soit au niveau O en même temps que l'état du moyen PO est au niveau 1, soit une augmentation d'une unité du rang t correspondant à la limite de repérage des moyens R, si cette dernière condition n'est pas satisfaite, cette évolution du rang t étant conditionnée par l'état de la sortie des moyens PO et Pt avant décalage, le nouveau rang t ne devenant efficace qu'après décalage, l'application des moyens U fournissant les combinaisons successives dont la présence est déterminée par un niveau O sur la sortie de la bascule QPO, les moyens U comprenant un moyen V qui permet de reporter l'état de la bascule Pt vers l'entrée de la bascule Po, les moyens R de repérage, d'initialisation, et d'évolution du rang t, étant constitués par un registre à décalage F à N+1 bascules numérotées 1 à N+1, ce registre étant chargé par t niveaux 1 sur les t premières bascules et par N−t+1 niveaux O sur les bascules suivantes, les N+1 sorties (QF1, QF2,...QFN+1) du registre F servant à valider ou non les décalages et à sélectionner la bascule Pt en détectant la transition 1, 0 sur le registre F pour reporter l'état de la bascule Pt vers le moyen PO, QF1 validant le transfert entre PO et P1, QF2 validant le transfert entre P1 et P2,...,QFN validant le transfert entre $P_{N-1}$ et $P_N$ et la bascule QFN+1 détectant la transition 1, 0, quelle que soit la valeur de N.

Selon un autre mode de réalisation particulier, les moyens de mémorisation (P1, P2...PN) de l'ensemble P sont constitués par N bascules formant un registre à décalage.

Selon un encore autre mode de réalisation particulier les moyens de repérage et d'initialisation R comprennent en outre des moyens pour intialiser F de sorte que t=2.

Selon un mode de réalisation particulier du moyen V le moyen V comprend, pour chacune des bascules de l'ensemble P, une porte ET dont une entrée est reliée à la sortie $QP_b$ de la bascule le $P_b$ correspondante, pour b compris entre 1 et N, les autres entrées de cette porte étant reliées respectivement à la sortie QFb de même rang de la bascule $F_b$ du registre F et à la sortie $QF_{b+1}$ de la bascule FB+1, de rang immédiatement supérieur, le niveau logique de la sortie de la bascule $P_t$ n'étant reporté vers l'entrée de la bascule PO que si la sortie $QF_b$ correspondante du registre F est au niveau 1 et si la sortie $QF_{b+1}$ de rang directement supérieur est au niveau O, les moyens V comprenant en outre une porte OU dont les entrées sont reliées aux sorties des portes ET, la sortie de cette porte OU transmettant à la bascule PO, la seule information correspondant au niveau logique de la sortie de la bascule $P_t$ et qui a été détecté par la transition de niveaux 1, 0 sur les niveaux logiques de sortie de registre F, les moyens U qui provoquent la succession de décalages comprenant en outre des moyens W reliés aux entrées de commande de décalages des bascules de l'ensemble de mémorisation P et aux sorties du registre à décalage F reliées elles-mêmes aux moyens V, pour commander les opérations de décalages entre les bascules de l'ensemble P, et un moyen de contrôle x relié d'une part aux moyens W de commande des opérations de décalages entre les bascules de l'ensemble P et d'autre part, à la sortie QPO de la bascule PO, ce moyen X permettant, soit de réinitialiser la limite t de repérage du moyen de repérage et d'initialisation R, soit d'augmenter de une unité le rang de cette limite.

Selon un autre mode de réalisation du moyen V, le moyen V comporte, pour chacune des bascules de l'ensemble P, une porte ET dont une entrée est reliée à la sortie $QP_b$ de la bascule $P_b$ correspondante, pour b compris entre 1 et N, les autres entrées de cette porte étant reliées respectivement aux sorties $QP_{b-1}$ et $QP_{b-2}$ des bascules $P_{b-1}$ et $P_{b-2}$ de l'ensemble P et à la sortie $QF_b$ de la bascule $F_b$ de même rang du registre F, le niveau logique à la sortie de la bascule $P_t$ n'étant reporté vers l'entrée de la bascule PO que si la sortie $QF_b$ correspondante du registre F est au niveau 1 et si $QP_b=1$, $QP_{b-1}=1$ et $QP_{b-2}=0$, les moyens V comportant en outre une porte OU dont les entrées sont reliées aux sorties des portes ET, la sortie de cette porte OU transmettant à la bascule PO, la seule information correspondant au niveau logique de la sortie de la bascule $P_t$ et qui a été détectée en correspondance avec la transition 1, O sur les niveaux logiques de sorties du registre F, les moyens U qui provoquent la succession de décalages comprennent en outre des moyens W reliés aux moyens V et aux entrées de commande de décalages des bascules de l'ensemble de mémorisation P et aux sorties du registre à décalage F, pour commander les opérations de décalages entre les bascules de l'ensemble P, et un moyen de contrôle X relié d'une part aux moyens W de commande des opérations de décalages entre les bascules de l'ensemble P et d'autre part, à la sortie QPO de la bascule PO, ce moyen X permettant, soit de réinitialiser la limite t de repérage du moyen de repérage et d'initialisation R, soit d'augmenter de une unité le rang de cette limite.

Selon un autre mode de réalisation particulier, les moyens W de commande de décalage sont contitués par un circuit logique provoquant, par l'intermédiaire des moyens de chargement CH et du moyen de contrôle X, des décalages simultané de l'état du moyen de mémorisation PO vers le moyen P1 et de chacun des moyens Pj vers le moyen suivant Pj+1 pour tous les moyens Pj dont le rang est compris entre 1 et t−1, les moyens Pk ne changeant pas d'état pour tous les moyens de mémorisation Pk de rang supérieur à t, le moyen de mémorisation PO étant chargé par l'état du moyen Pt de rang t au cours de cette opération de décalage, le moyen X de contrôle du moyen de repérage R, commandant, par des niveaux logiques correspondant à une combinaison prédéterminée sur certains moyens de mémorisation, les décalages entre les bascules du registre F, par l'intermédiaire des moyens CH de chargement des moyens de mémorisation P, les moyens U qui provoquent une succession d'opérations de décalage entre les bascules de l'ensemble p comprenant en outre des moyens Z reliés au moyen de mémorisation PO pour indiquer qu'une combinaison est présente sur les sorties des moyens de mémorisation de l'ensemble P ou pour commander le démarrage des opérations de recherche d'une autre combinaison, ces moyens Z d'indication et de commande de démarrage étant en outre connectés à la sortie d'une horloge de commande des différentes opérations de décalage et à la sortie QPO de la bascule PO afin de repérer la présence du niveau logique 0 sur la sortie QPO, de manière à arrêter l'horloge et indiquer la présence d'une combinaison disponible sur p sorties de l'ensemble P, our de manière à redémarrer l'horloge pour la recherche d'une autre combinaison, cette horloge commandant les opérations de décalages par l'intermédiaire des moyens A d'arrêt de génération de combinaison, des moyens de contrôle X et des moyens CH de chargement des bascules de l'ensemble P, les moyens A d'arrêt de génération de combinaison comportant un compteur CPPO chargé à la valeur N−1 par les moyens de chargement (CH), à l'initialisation du rang t déterminé par les moyens d'initialisation et de repérage R, ce compteur étant activé à chaque augmentation d'une unité du rang t, de manière que les opérations de décalages soient arrêtées lorsque son contenu atteint O, ce moyen de comptage comportant de plus une porte ET reliée à la sortie du compteur et à la sortie de l'horloge, la sortie de cette porte commandant les opérations de décalages par l'intermédiaire des moyens de contrôle X et des moyens CH de chargement des bascules de l'ensemble P.

Selon une autre mode de réalisation particulier, les registres F des moyens R, les bascules de l'ensemble P, les moyens V de report de l'état de la bascule $P_t$ vers la bascule PO, forment un module, le générateur comportant une pluralité de ces modules connectés en cascade, de sorte que la sortie de la dernière bascule d'un ensemble P d'un module, soit reliée à l'entrée de la première bascule de l'ensemble P du module suivant, la sortie de la dernière bascule des moyens de repérage R d'un module étant reliée à l'entrée de la première bascule du moyen de repérage du module suivant, chaque sortie des portes OU des moyens V de report du niveau logique de la sortie de la bascule $P_t$ vers l'entrée de la bascule PO, étant reliée à cette entrée par un transistor monté en "collecteur ouvert", la sortie QPO de la bascule PO étant reliée à l'entrée de la première bascule de l'ensemble P du premier module, les bascules des moyens de mémorisation des ensembles P des modules et les bascules des moyens R de repérage et d'initialisation des modules étant reliées aux moyens de chargement CH.

Selon un autre mode de réalisation particulier, le générateur comprend en outre un circuit logique de blocage de génération des combinaisons, à partir d'une combinaison prédéterminée, ce circuit logique présentant des entrées reliées à des sorties des moyens de mémorisation (P) qui correspondent aux sorties fournissant ladite combinaison prédéterminée, et une sortie de commande de blocage du l'horloge (H).

Selon un autre mode de réalisation particulier, et pour un autre mode de réalisation du générateur, pour former les combinaisons de p=2 sorties au niveau logique 1 et de N−p sorties au niveau logique 0, parmi les N sorties (QP1...QPN) du générateur, l'ensemble p des N moyens de mémorisation $(P_1...P_N)$ comprend un groupe de deux registres à décalage J, k constitués respectivement par N−1 bascules (J1,...JN−1, K2,...KN), les sorties $(QJ_1...QJN−1)$ du premier registre J étant repérées de 1 à N−1 et les sorties (QK₂...QKN) du deuxième registre K étant repérées de 2 à N, la première sortie (QP1) des moyens de mémorisation P étant constituée par la sortie (QJ1) de la première bascule (J1) du premier registre (J) et la dernière sortie (QPN) des moyens de mémorisation P étant constituée par la sortie (QKN) de la dernière bascule (KN) du deuxième registre (K), l'ensemble de mémorisation (P) comprenant en outre un ensemble de N−2 portes OU à deux entrées, les deux entrées de ces portes OU étant respectivement connectées aux sorties (QJ2, QK2, QJ3, QK3...QJN−1, QKN−1) correspondantes des bascules de même rang (J2, K2, J3, K3...JN−1, KN−1) des registres (J, K), les sorties de ces portes OU constituant respectivement les sorties (QP2...QPN−1) des moyens de mémorisation P, les moyens de chargement (CH) appliquant des signaux d'initialisation, de remise à zéro et de décalage sur des entrées correspondantes des registres (J, K) et les moyens (M) de commande étant reliés aux sorties des registres à décalage (J, K) pour commander la génération des combinaisons, par l'intermédiaire des moyens de chargement (CH) et des moyens d'arrêt (A), les moyens M comprenant des moyens (D) dont les entrées sont reliées aux sorties des registres à décalage (J, K) pour détecter si une bascule de rang j du premier registre (J) et une bascule de rang k=j+1 du deuxième registre (K) sont à un niveau 1, j pouvant varier de 1 à N−1 et k de 2 à N, des moyens de contrôle (X) dont une entrée de commande est reliée à une sortie des moyens de détection (D) et dont des sorties sont reliées à des entrées de commande des moyens de chargement (CH) pour déclencher, soit un décalage d'un rang du contenu du premier registre (J) si les moyens de détection (D) n'ont pas détecté deux niveaux 1 successifs sur les sorties de rang j et k successifs de deux bascules des deux registres (J, K), soit un décalage d'un rang du contenu du deuxième registre (K) et une réinitialisation du contenu du premier registre (J), de façon que la sortie (QJ1) de la première bascule (J1) du premier registre (J) soit à un niveau 1 et que les autres sorties (QJ2...QJN−1) de rang 2 à N−1 de ce premier registre (J) soient un niveau 0, des moyens (Z) pour indiquer qu'une combinaison est présente sur les sorties (QP1...QPN) des moyens de mémorisation (P) ou pour commander la recherche d'une autre combinaison, ces moyens (Z) d'indication et de commande de recherche de combinaison recevant sur des entrées des signaux d'initialisation, de validation ou de commande de recherche d'une autre combinaison, une sortie de ces moyens fournissant un signal indicateur de présence d'une combinaison sur les sorties des moyens de mémorisation (P), une autre sortie de ces moyens étant reliée à une entrée d'un circuit de validation (VA) des opérations effectuées par les moyens de chargement (CH) à partir des impulsions d'une horloge (H) dont la sortie est reliée à une autre entrée des moyens de validation (VA), les moyens d'arrêt (A) présentant une sortie qui est reliée à une autre entrée des moyens de validation (VA) pour bloquer ces moyens de validation lorsque les combinaisons désirées ont été obtenues, ces moyens d'arrêt (A) recevant sur des entrées, les signaux de réinitialisation et de commande de décalage, appliqués au premier registre (J), les moyens de détection (D) étant constitués par N−1 portes ET à deux entrées, ces portes étant repérées de 1 à N−1, les entrées de chaque porte étant respectivement reliées à la sortie de la bascule de même rang du registre J et à la sortie de la bascule de rang immédiatement supérieur du registre K, les sorties de ces portes ET étant reliées aux entrées d'une porte OU dont la sortie est reliée à l'entrée de commande des moyens de contrôle (X), les moyens d'arrêt (A) étant constitués par un compteur chargé à la valeur N−1 à chaque initialisation du premier registre (J), ce compteur décomptant d'une unité à chaque décalage du contenu de ce premier registre (J).

Selon un autre mode de réalisation, le générateur comprend en outre un circuit logique de blocage de génération de combinaisons, à partir d'une combinaison prédéterminée, ce circuit logique présentant des entrées reliées à des sorties des moyens de mémorisation (P) correspondant aux sorties fournissant ladite combinaison prédéterminée, et une sortie de commande de blocage de l'horloge (H).

Enfin, selon encore un autre mode de réalisation particulier, le générateur comprend und pluralité de groupes de registres (J) et (K) reliés en série, une pluralité d'ensembles de portes OU à deux entrées associées respectivement aux groupes de registres à décalage (J, K), et une pluralité de moyens de détection (D) associés respectivement aux groupes de registres à décalage (J, K), un groupe de registres (J, K) ainsi que les moyens de détection (D) et l'ensemble de portes OU qui correspondent à ce groupe formant un module, les sorties des portes OU des moyens de détection (D) étant reliées à l'entrée de commande des moyens de contrôle (X), par l'intermédiaire d'un transistor monté en collecteur ouvert.

L'invention est exposée dans la description qui va suivre donnée en référence aux dessins annexés dans lesquels:

— les figures 1A et 1B représentent schématiquement le générateur de combinaison de l'invention;
— la figure 2 est un tableau qui donne toutes les combinaisons de signaux logiques à un niveau 1, obtenues sur p sorties du générateur de l'invention, parmi les N sorties que comporte ce générateur, les N−p sorties restantes étant au niveau logique O. Il est supposé dans ce tableau que le générateur de combinaison représenté en exemple comprend N=5 sorties et que l'on effectue les combinaisons de p=3 de ces sorties, au niveau logique 1;
— la figure 3 est un tableau qui représente de manière plus détaillée l'état des bascules de l'ensemble de mémorisation P du générateur de l'invention, pour passer d'une combinaison à une autre dans le tableau de la figure 2;
— la figure 4 est une tableau qui représente l'état logique de toutes les bascules de l'ensemble P de mémorisation du générateur de l'invention, au cours de l'obtention de toutes les combinaisons possibles grâce au générateur de la figure 1 qui comporte N=5 sorties, les signaux logiques combinés, de niveau 1, étant disponibles sur p=3 de ces sorties;
— la figure 5 est un organigramme qui permet de mieux comprendre le fonctionnement du générateur de l'invention;
— la figure 6 représente schématiquement le générateur de l'invention, dans le cas où celui-ci est construit sous forme modulaire;
— les figures 7A et 7B représentent schématiquement, un autre mode de réalisation du générateur de l'invention;
— la figure 8 est un tableau qui représente l'état logique de toutes les bascules de l'ensemble de mémorisation P, pour ce second mode de réalisation du générateur dans lequel p=2.

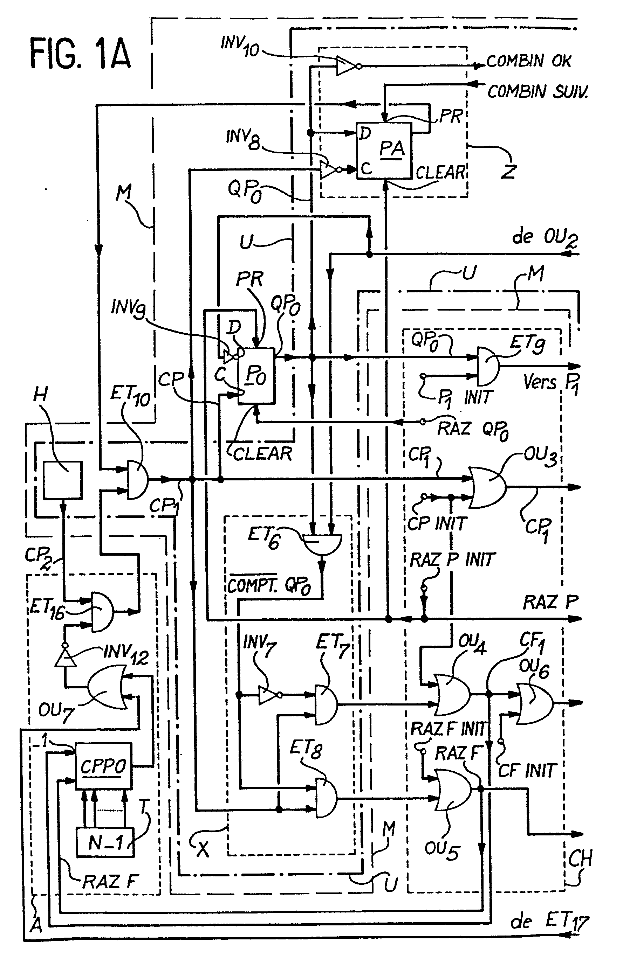

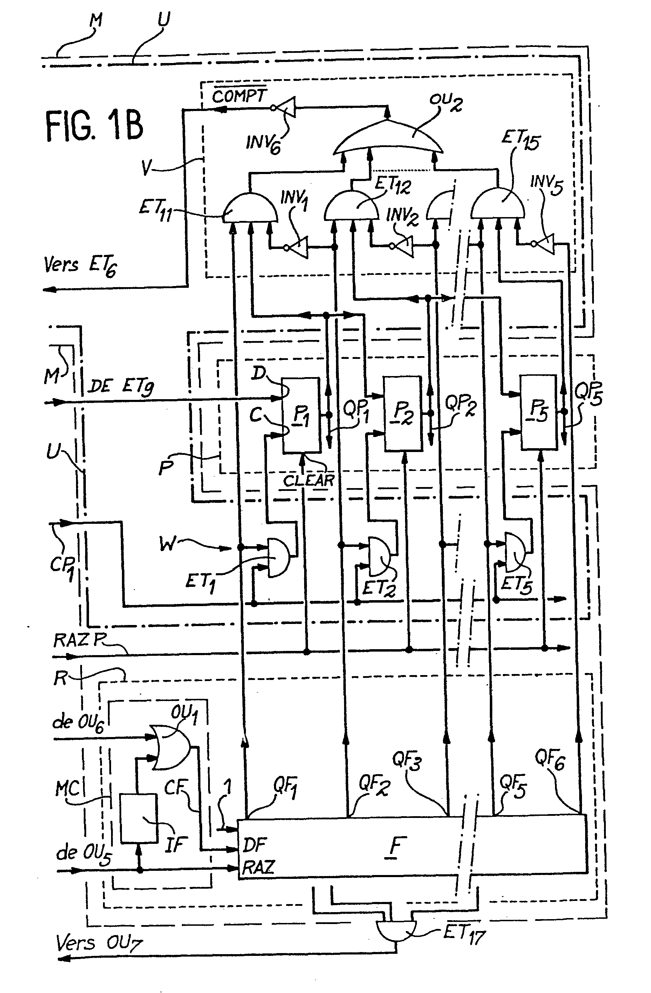

En référence aux figures 1A et 1B, on a représenté schématiquement un générateur de signaux logiques combinés, conforme à l'invention. Ce générateur permet de former des combinaisons de p sorties au niveau logique 1 et N−p sorties au niveau logique O, parmi les N sorties (QP1,...QPN) que comporte ce générateur. Dans le mode de réalisation représenté en exemple, on suppose que ce générateur comporte N=5 sorties et qu'il permet de former des combinaisons de p=3 sorties au niveau logique 1 et N−p=2 sorties au niveau logique 0, parmi les 5 sorties QP1, QP2,...QP5 du générateur. Il comprend un ensemble ordonné P de N moyens de mémorisation (P1, P2,...PN) qui sont repérés du rang 1 au rang N; les combinaisons des p-sorties au niveau 1 et des N−p sorties au niveau O sont fournies sur les sorties QP1,...QPN de ces moyens de mémorisation. Dans l'exemple de réalisation représenté sur la figure, les moyens de mémorisation de l'ensemble P sont constitués par des bascules P1, P2,...P5, de type D; ce sont par exemple des bascules de la série 74LS/174 commercialisées par la Société Texas Inst. Le générateur de combinaisons comprend aussi des moyens CH qui seront décrits plus loin en détail et qui permettent de charger dans les bascules de l'ensemble P de mémorisation, des niveaux logiques correspondant à une combinaison particulière que l'on désire obtenir sur les sorties QP1,...QPN, du générateur. Enfin, il comprend des moyens de commande M qui permettent, comme on le verra par la suite, en association avec des moyens de comptage A, d'assurer des décalages et des transferts entre les bascules de l'ensemble de mémorisation P, pour assurer la présentation sur les sorties des bascules de l'ensemble P, de toutes les combinaisons que l'on peut obtenir, à partir de cette combinaison particulière.

Les moyens de commande M, comme on le verra plus loin en détail, permettent de repérer le moyen de mémorisation $P_i$ de l'ensemble P, qui est défini comme étant le moyen dont la sortie est au niveau logique 1 et qui est immédiatement suivi par le moyen de mémorisation $P_{i+1}$ dont la sortie est au niveau logique 0, le rang i étant le plus faible possible. Les moyens M permettent de ramener, sur tous les moyens de mémorisation qui précèdent éventuellement le moyen $P_i$, une succession de niveaux logiques 1, en commençant par le moyen de mémorisation $P_1$ de rang 1, jusqu'au moyen $P_n$ de rang n inclus; n est égal au nombre de niveaux 1 qui existent sur les moyens de mémorisation qui précèdent le moyen $P_i$; cette succession de niveaux logiques 1 est complétée éventuellement par des niveaux logiques 0 après le moyen de mémorisation de rang n et avant le moyen de mémorisation de rang i. Les moyens de commande M permettent aussi de remplacer l'état logique du moyen de mémorisation $P_i$, par un niveau logique O, et l'état logique des moyens de mémorisation $P_{i+1}$ par un niveau logique 1. Comme on va le voir, l'application répétée du moyen de commande M fournit toutes les combinaisons qui suivent la combinaison particulière mentionnée plus haut.

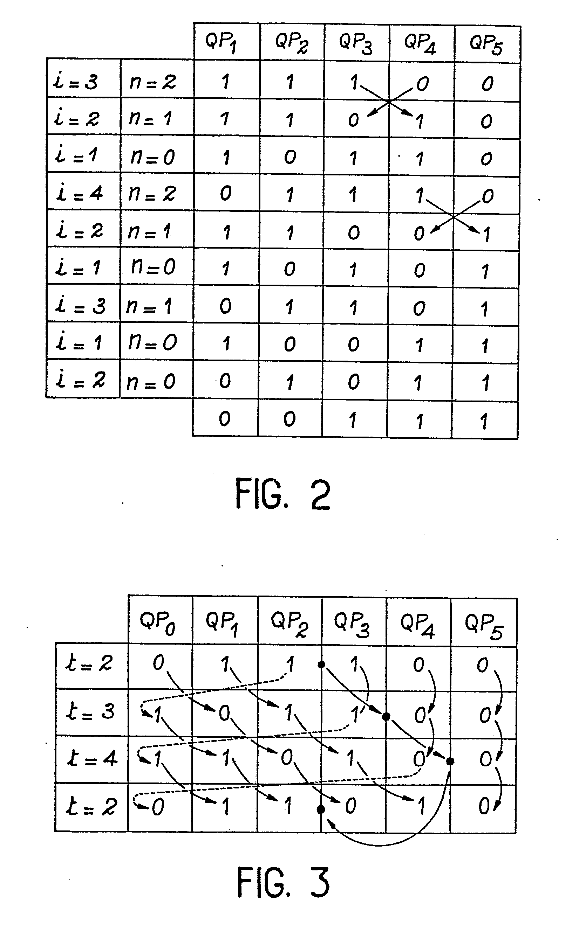

Le fonctionnement des moyens de commande M dont le principe vient d'être expliqué d'une manière très générale plus haut, sera mieux compris en se référant au tableau de la figure 2 qui donne l'état logique des sorties QP1, QP2,...QP5 des bascules P1, P2...P5 de l'ensemble de mémorisation P du générateur représenté en exemple sur la figure 1.

Sur le tableau de la figure 2, on suppose, qu'au départ, ce sont les trois premières sorties QP1, QP2, QP3 du générateur qui présentent un niveau logique 1, alors que les sorties restantes, QP4, QP5, présentent un niveau logique O. Ces états logiques sont représentés sur la première ligne du tableau de la figure 2. Les moyens M permettent de repérer le moyen de mémorisation $P_i$, qui est défini comme étant un moyen dont la sortie est au niveau logique 1 et qui est immédiatement suivi par le moyen de mémorisation $P_{i+1}$ dont la sortie est au niveau logique 0, i étant le plus faible possible. Sur la première ligne du tableau de la figure 2, le moyen de mémorisation $P_i$ est la bascule $P_3$ (i=3) tandis que le moyen de mémorisation $P_{i+1}$ est la bascule $P_4$. En effet, la bascule $P_3$ dont la sortie $QP_3$ est au niveau 1, est immédiatement suivie de la bascule $P_4$ dont la sortie $QP_4$ est au niveau logique O. Le rang i est toujours le plus faible possible, c-est-à-dire que les moyens M permettent de détecter la première transition 1,0 sur les sorties QP des bascules de l'ensemble P. Les moyens M permettent de ramener, sur tous les moyens de mémorisation qui précèdent le moyen $P_i$ ($P_3$ dans l'exemple considéré), une succession de niveaux logiques 1, en commençant par le moyen de mémorisation $P_1$, jusqu'au moyen de mémorisation de rang n inclus, n étant égal au nombre de niveaux 1 qui existent sur les moyens de mémorisation qui précèdent le moyen $P_i$; dans l'exemple considéré, les moyens de mémorisation $P_1$, $P_2$ qui précèdent le moyen $P_3$ présentent des sorties qui sont au niveau logique 1; ces sorties ne changent donc pas d'état logique. Les moyens de commande M permettent aussi de remplacer l'état du moyen de mémorisation $P_i$ par un niveau O et l'état du moyen de mémorisation $P_{i+1}$ par un niveau 1. Dans l'exemple représenté sur le tableau de la figure 2 et à la deuxième ligne de ce tableau, on voit que le niveau logique 1 de la bascule $P_3$ a été remplacé par un niveau logique O, alors que le niveau logique O de la bascule $P_4$ a été remplacé par un niveau logique 1. Toutes les autres bascules qui suivent la bascule $P_{i+1}$ (P5 dans l'exemple considéré-deuxième ligne du tableau) ne changent pas d'état.

La deuxième ligne du tableau représente la deuxième combinaison des trois sorties (QP1, QP2, QP4) du générateur, qui présentent un niveau logique 1, les deux sorties restantes (QP3, QP5) étant au niveau logique O. Pour cette deuxième combinaison, i=2 et n=1.

Comme on l'a indiqué plus haut, les moyens M permettent de compléter la succession de niveaux logiques 1 qui ont été remenés sur les bascules qui précèdent la bascule $P_i$, par des niveaux logiques O ramenés éventuellement sur toutes les bascules qui suivent la bascule de rang n et qui précèdent la bascule de rang i. C'est ainsi par exemple, que pour passer de la quatrième combinaison à la cinquième sur les sorties du générateur (représentées sur les quatrième et cinquième lignes du tableau de la figure 2), on part de i=4 et n=2 (quatrième combinaison). Le moyen M fait passer la bascule P5 à l'état logique 1, la bascule P4 à l'état logique O, ramène des niveaux logiques 1 sur les bascules qui précèdent la bascule P4, excepté sur la bascule P3 qui est ramenée à l'état logique O, puisque c'est la seule bascule qui est située entre les bascules de rangs i=4 et n=2. La cinquième combinaison est alors disponible sur les sorties du générateur. Les autres combinaisons disponibles sur les sorties du générateur de la figure 1, sont représentées sur les différentes lignes du tableau de la figure 2 et sont obtenues comme décrit plus haut.

On a supposé dans ce tableau de la figure 2 que la combinaison prédéterminée de départ est celle qui permet d'obtenir des niveaux 1 sur les sorties des premières bascules ($P_1$, $P_2$, $P_3$) de l'ensemble de mémorisation P, mais il est bien évident que cette première combinaison prédéterminée de départ peut être celle qui est représentée sur l'une quelconque des lignes du tableau de la figure 2.

La figure 3 représente de manière plus détaillée l'état des bascules de l'ensemble de mémorisation P du générateur, au cours des opérations qui permettent de passer d'une combinaison à une autre. Les états des bascules représentées sur ce tableau sont ceux qui permettent de passer de la première combinaison disponible à la seconde combinaison (passage de la ligne 1 à la ligne 2 dans le tableau de la figure 2). Il est bien évident que ce tableau s'applique au générateur représenté en exemple, qui comporte N=5 sorties et qui permet d'obtenir sur p=3 de ces sorties, toutes les combinaisons de niveau logique 1. Le moyen M de commande, qui permet de repérer le moyen de mémorisation $P_i$ et d'effectuer les opérations décrites plus haut, sur toutes les bascules qui précèdent la bascule $P_i$, ainsi que sur la bascule $P_{i+1}$ comprend des moyens R, qui sont reliés aux moyens de chargement d'une combinaison particulière, dans les bascules de l'ensemble P. Ces moyens R permettent de repérer et d'initialiser le rang t des moyens de mémorisation de l'ensemble P qui suit le premier moyen de mémorisation dont la sortie est au niveau logique 1, et de faire évoluer la limite t du repérage. Les moyens de commande M comprennent aussi un moyen de mémorisation PO dont la sortie est QPO. Dans le tableau, on a aussi représenté le niveau logique de la sortie QPO de la bascule PO, au cours du fonctionnement du système, pour passer de la première combinaison à la seconde combinaison. En fait, dans l'exemple considéré, les moyens R permettent de repérer, à la première ligne de ce tableau, la bascule P2 du rang t=2, dont la sortie est au niveau logique 1; en effet, cette bascule est celle qui suit la première bascule P1 dont la sortie QP1 est au niveau logique 1. Ce repérage du rang t est figuré par un point dans le tableau; ce point qui est placé entre la sortie de la bascule de rang t et la sortie de la bascule de rang t+1 indique que les décalages ne se produisent plus après la bascule de rang t. Enfin, les moyens M comprennent des moyens U qui provoquent une succession d'une ou plusieurs opérations du décalage entre les bascules P1...PN de l'ensemble P, par l'intermédiaire des moyens de repérage R et des moyens de chargement CH. Comme on le verra plus loin en détail, ces opérations de décalage sont effectuées jusqu'à ce que l'état de la sortie QPO de la bascule PO soit au niveau O. Chaque opération de décalage réalise des décalages simultanés de l'état logique de la bascule PO, vers le moyen de mémorisation P1 et de chacun des moyens $P_j$ de rang j, vers le moyen de mémorisation suivant $P_{j+1}$ de rang j+1, pour tous les moyens $P_j$ dont le rang est compris entre 1 et t−1, de sorte que les moyens de mémorisation $P_k$ de rang k, ne changent pas d'état lorsque le rang k de ces moyens de mémorisation est supérieur à t. Le moyen de mémorisation PO est chargé par l'état de la sortie du moyen de mémorisation $P_t$ de rang t, au cours de cette opération de décalage. Chaque opération de décalage provoque aussi, comme on le verra plus loin en détail, soit une réinitialisation de la limite t de repérage fournie par le moyen R, à condition que la sortie du moyen de mémorisation $P_t$ soit au niveau O en même temps que l'état du moyen PO est au niveau 1, soit une augmentation d'une unité du rang t correspondant à la limite de repérage des moyens R, si cette dernière condition n'est pas satisfaite. Cette évolution du rang t est conditionnée par l'état de la sortie des moyens PO et $P_t$, avant décalage; le nouveau rang t ne devient efficace qu'après décalage. Comme on le verra plus loin, l'application répétée du moyen U fournit les combinaisons successives dont la présence est déterminée par un niveau O sur la sortie de la bascule QPO.

Comme indiqué sur la première ligne du tableau de la figure 3, qui donne les niveaux logiques sur les sorties des bascules PO, P1...P5, les moyens R de repérage permettaient de repérer le rang t=2 de la bascule P2 dont la sortie QP2 est au niveau 1, cette bascule suivant immédiatement la première bascule P1 dont la sortie QP1 est au niveau logique 1. Dans l'exemple considéré, la bascule de rang t=2 étant repérée, les moyens de mémorisation $P_j$ de rang j sont consitués par la bascule P1, puisque le rang j est compris entre 1 et t−1. Il en résulte, que lors de la première opération de décalage qui fait passer les bascules de l'ensemble P, des états représentés sur la première ligne du tableau, à ceux qui sont représentés sur la deuxième ligne, l'état logique O de la bascule PO est transmis à la bascule P1, l'état logique de la bascule P1 est transmis à la bascule P2, et que les états des bascules P3, P4, P5, de rang k supérieur à t=2, ne changent pas. Le moyen de mémorisation PO est chargé par l'état logique 1 de la bascule P2 de rang t=2. Avant cette première opération de décalage, la bascule P2 de rang t=2 présentait sur

sa sortie QP2 un niveau logique 1, tandis que la bascule PO présentait également sur sa sortie QPO un niveau logique 0. Dans ces conditions, les moyens R permettent de modifier la limite t de repérage des moyens de mémorisation de l'ensemble P, en augmentant d'une unité le rang de cette limite t. C'est ce qui apparaît à la deuxième ligne du tableau où la limite t est égale à 3. Une nouvelle opération de décalage, comparable à celle qui a été décrite plus haut, va être effectuée jusqu'à cette limite. Comme précédemment, l'état logique de la bascule PO est transmis à la bascule P1; l'état logique de la bascule P1 est transmis à la bascule P2, l'état logique de la bascule P2 est transmis à la bascule P3, tandis que les bascules P4 et P5 convervent leur état logique, puisque leur rang k est supérieur à t=3. De la même manière que précédemment, au cours d'une nouvelle opération de décalage, l'état logique de la bascule P3 de rang t=3 est transmis à la bascule PO. A la fin de ces opérations de décalage, les différentes bascules sont dans les états logiques qui sont représentés sur la troisième ligne du tableau. On voit ici encore que, avant décalage, la bascule P3 de rang t=3 était au niveau logique 1, alors que la bascule PO était au niveau logique 1. Dans ces conditions, les moyens R augmentent d'une unité, la limite de repérage t des bascules de l'ensemble P, et il en résulte qu'après les opérations de décalage qui viennent d'être décrites, cette limite t est égale à 4; elle correspond à la sortie QP4 de la bascule P4. Les opérations de décalage décrites précédemment recommencent alors de la même manière: le niveau logique de la bascule PO est transmis à la bascule P1, le niveau logique de la bascule P1 est tarnsmis à la bascule P2, le niveau logique de la bascule P2 est transmis à la bascule P3, le niveau logique de la bascule P3 est transmis à la bascule P4. La bascule P5 de rang 5, supérieur à t=4 ne change pas d'état. Le niveau logique de la bascule P4 de rang t=4 est transmis à la bascule PO, tandis que la bascule P5 de rang supérieur à la limite t=4 ne change pas d'état. A la fin des opérations de décalage, la bascule P4 de rang t=4 présente un niveau logique 1, tandis que la bascule PO présente un niveau logique 0. La bascule PO présentant un niveau logique O, il en résulte que les niveaux logiques représentés sur la quatrième ligne du tableau correspondent à une combinaison de niveaux disponibles sur les sorties QP1, QP2,...QP5 du générateur.

Comme la bascule P4 de rang t=4 présentait avant décalage, un niveau logique 0, tandis que la bascule PO présentait un niveau logique 1, les moyens R permettent d'initialiser le rang t de repérage, comme cela était décrit pour la première ligne du tableau: lorsqu'il s'agit d'une combinaison de niveaux disponibles sur les sorties $QP_1,...QP_5$ du générateur, la limite t de repérage est fixée par le rang de la bascule qui suit immédiatement la première bascule dont l'état logique est 1. Cette bascule est la bascule P2 et le rang t est donc égal à 2. C'est à partir de cette limite de repérage que doivent être effectuées les nouvelles opérations de décalage pour rechercher la combinaison suivante de trois sorties qui présentent un niveau logique 1. Dans le cas de l'exemple qui vient d'être décrit, ces nouvelles opérations de décalage permettent d'obtenir la combinaison représentée sur la deuxième ligne du tableau de la figure 2.

Les moyens R de repérage, d'initialisation et d'évolution du rang t, sont constitués par un registre à décalage F qui comprend $N+1$ bascules numérotées de 1 à $N+1$; ce registre est chargé par t niveaux 1 sur les t premières bascules et $N-t+1$ niveaux O sur les bascules suivantes: les $N+1$ sorties (QF1, QF2,...QFN+1) servent à valider ou non les décalages entre les bascules de l'ensemble de mémorisation P et à sélectionner la bascule $P_t$ en détectant la transition 1,0 sur le registre F, pour reporter l'état de la bascule $P_t$ vers le moyen PO. QF1 valide de transfert entre PO et P1, QF2 valide le transfert entre P1 et P2...QFN valide le transfert entre les bascules PN−1 et PN. La bascule QFN+1 permet de détecter la transition 1,0 quel que soit N. Comme on l'a vu précédemment, à l'initialisation du générateur, lorsque celui-ci présente la première combinaison disponible ($t=2$), les deux premières bascules du registre à décalage F présentent sur leurs sorties QF1 et QF2 des niveaux logiques 1, tandis que les autres sorties QF3...QF6 présentent un niveau logique 0. L'évolution du registre à décalage F est réalisée par l'intermédiaire d'un module de commande MC qui comprend une porte OU1 dont une entrée reçoit des impulsions CF1 de commande de décalage, en provenance de moyens qui seront décrits plus loin en détail; une autre entrée de la porte OU1 est reliée à un circuit d'initialisation IF qui permet, à l'initialisation du registre F par un signal RAZF, d'appliquer au registre à décalage deux impulsions CF sur son entrée de commande de décalage DF. Ce circuit est conçu de façon classique de sorte que lorsqu'il reçoit une impulsion à l'entrée, il fournit deux impulsions retardées par rapport à la première, sur sa sortie. Une entrée de commande de ce registre à décalage est portée en permenence au niveau logique 1, de manière à propager ce niveau logique dans les différentes bascules à chacune des impulsions CF. Les décalages entre les bascules P1...P5 de l'ensemble de mémorisation P, sont commandés par des impulsions CP1 provenant de moyens qui seront décrits plus loin en détail; ces impulsions sont appliquées à l'une des entrées de portes ET1, ET2...ET5, appartenant à des moyens de commande W d'opérations de décalage; les autres entrées de ces portes sont respectivement connectées aux sorties QF1, QF2...QF5 du registre à décalage F. Les sorties de chacune de ces portes sont respectivement reliées aux entrées de commande de décalage C des bascules P1...P5 de l'ensemble P. Ces portes, en association avec le registre F, permettent de faire des décalages simultanés de l'état logique de la bascule PO vers la bascule P1 et de chacune des bascules $P_j$ vers la bascule $P_{J+1}$, pour toutes les bascules $P_j$ dont le rang est compris entre 1 et t−1, les bascules de rang $k>t$ ne changeant pas d'état et la bascule PO étant chargée par l'état logique de la bascule $P_t$ de rang t, telle qu'on l'a défini précédemment dans l'explication du tableau de la figure 3.

Les moyens U qui provoquent une succession d'opérations de décalage entre les N bascules de l'ensemble de mémorisation P, comprennent également un moyen V qui permet de reporter l'état de la bascule $P_t$ vers l'entrée D de la bascule PO. Cette bascule, comme les bascules de l'ensemble P, est une bascule de type D dont l'entrée D est une entrée qui détermine l'état de la bascule. Cet état est mémorisé par l'application d'un signal d'horloge CP sur l'entrée C de la bascule. L'état mémorisé de cette bascule est disponible sur la sortie QPO de celle-ci. Cette bascule présente deux entrées supplémentaires. L'entrée PR qui permet de mettre la bascule à l'état 1 en appliquant un niveau O sur cette entrée, et l'entrée CLEAR qui permet de mettre cette bascule à l'état O en appliquant un O sur cette entrée. En fonctionnement normal, les entrées CLEAR et PR sont au niveau 1. Cette bascule peut par exemple être celle du type SN 54—74L74 commercialisée par la Société Texas Instruments. Le moyen V qui permet de reporter l'état de la bascule $P_t$ vers l'entrée de la bascule $P_0$ comprend les portes $ET_{11}$, $ET_{12}$...$ET_{15}$, de type ET. Ces portes sont en nombre égal à celui des bascules de l'ensemble P et chacune d'elles, dans un premier mode de réalisation des moyens V présente une entrée qui est reliée à la sortie $O_{Pb}$ de la bascule $P_b$ correspondante de l'ensemble P. Les autres entrées de chacune de ces portes sont reliées respectivement à la sortie $Q_{Fb}$ de même rang b de la bascule $F_b$ du registre F et à la sortie $Q_{Fb+1}$ de la bascule $F_{b+1}$ de rang immédiatement supérieur. C'est ainsi par exemple que la porte $ET_{11}$ á l'une de ses entrées qui est reliée à la sortie QP1 de la bascule P1, tandis que les deux autres entrées de cette porte sont reliées respectivement aux sorties QF1 et QF2 des bascules du registre F. La sortie $Q_{Fb+1}$ du registre F est d'ailleurs reliée à l'entrée de la porte correspondante, par l'intermédiaire d'un amplificateur inverseur. Les amplificateurs inverseurs qui interviennent dans les moyens V sont référencés INV1, INV2...INV5 sur la figure.

Dans un autre mode de réalisation des moyens V, les portes ET des moyens V qui permettent de reporter l'état de la bascule $P_t$ vers l'entrée de la bascule PO, sont des portes à quatre entrées. Ces portes sont en nombre égal à celui des bascules de l'ensemble de mémorisation P. Pour une porte qui correspond par exemple à la bascule $P_b$, les entrées de cette porte sont reliées de la manière suivante: l'une des entrées est reliée à la sortie $Q_{Pb}$ de la bascule $P_b$, tandis que l'autre entrée est reliée à la sortie $Q_{Fb}$ du registre F; les deux autres entrées sont reliées respectivement aux sorties $Q_{Pb-1}$ et $Q_{Pb-2}$ des bascules $P_b$ et $P_{b-2}$ de l'ensemble de mémorisation P. La sortie $Q_{Pb-2}$ est reliée à l'entrée de la porte ET correspondante, par l'intermédiaire d'un amplificateur-inverseur.

Dans le premier mode de réalisation des moyens V qui permettent de reporter l'état de la bascule $P_b$ vers l'entrée de la bascule PO, le niveau logique de la sortie de la bascule $P_t$ n'est reporté vers l'entrée de la bascule PO que si la sortie $Q_{Fb}$ correspondante du registre F est au niveau 1 et si la sortie $Q_{Pb+1}$ de rang directement supérieur est au niveau O. C'est ainsi par exemple que dans le tableau de la figure 3 (lignes 1 et 2 de ce tableau), le niveau de sortie de la bascule P2 de rang t=2 est reporté à l'entrée de la bascule PO, si la sortie $QF_2$ du registre F est au niveau 1 et si la sortie QF3 de ce registre est au niveau O.

Dans le second mode de réalisation du moyen V qui permet de reporter l'état de la bascule $P_t$ vers l'entrée de la bascule PO, ce report n'est effectué que si $QP_b=1$, $QF_b=1$, $QP_{b-1}=1$ et $QP_{b-2}=0$.

Les moyens V comprennent aussi une porte OU2 qui fournit un signal COMPT. Ce signal est transformé par un amplificateur-inverseur INV 6 en un signal $\overline{COMPT}$; ce signal correspond au niveau logique de la sortie de la bascule $P_t$, qui a été détecté par la transition de niveau 1,0 sur la sortie du registre F, comme on l'a indiqué plus haut. Les moyens U qui provoquent les successions d'opérations de décalages entre les bascules de l'ensemble de mémorisation P, comprennent en outre des moyens W qui seront décrits plus loin en détail et qui permettent de commander les opérations de décalages entre les bascules de l'ensemble P, par l'intermédiaire de la bascule PO notamment. Ces moyens de commande W sont reliés au moyen V de report d'état de la bascule $P_t$; ils sont également reliés aux entrées de commande C des bascules de l'ensemble de mémorisation P et aux sorties $QF_1,...QF_5$ du registre à décalages F. Les moyens U comprennent aussi un moyen de contrôle X qui est relié d'une part aux moyens W de commande des opérations de décalages et, d'autre part, à la sortie QPO de la bascule PO; ce moyen X permet, soit de réinitialiser la limite t de repérage du moyen de repérage et d'initialisation R, soit d'augmenter d'une unité le rang de cette limite t. Ce moyen X comprend les portes ET6, ET7 et ET8, de type ET ainsi que l'inverseur INV7. La porte ET6 élabore le signal $\overline{COMPT}$. QPO; l'inverseur INV7 ainsi que la porte ET7 et ET8 constituent deux circuits de synchronisation, comme en le verra plus loin en détail. Un inverseur INV9 reçoit le signal $\overline{COMPT}$ et sa sortie est reliée à l'entrée D de la bascule PO. Les moyens de contrôle X permettent de gérer par l'intermédiaire des moyens de chargement CH et du registre à décalages F, les décalages simultanés de l'état de la bascule PO vers la bascule P1 et chacun des moyens $P_j$ vers le moyen $P_{j+1}$, pour tous les moyens $P_j$ dont le rang est compris entre 1 et t−1. Les moyens $P_k$ ne changent pas d'état pour toutes les bascules de rang $P_k$, de rang supérieur à t. Le moyen de mémorisation PO est chargé par l'état du moyen $P_t$ de rang t, au cours de cette opération de décalage. Comme on le verra plus loin en détail, les moyens de contrôle X du moyen de repérage R, peuvent permettre de commander les décalages entre les bascules du registre F, par l'intermédiaire des moyens de chargement CH, de manière à ce que les bascules de l'ensemble de mémorisation P présentent des niveaux logiques correspondant à une combinaison prédéterminée. Les moyens CH comprennent une porte ET9 dont une entrée est reliée à la sortie QPO de la bascule PO et dont une autre entrée reçoit, en cas de chargement d'une combinaison prédéterminée dans les bascules de l'ensemble P, un signal P1 INIT. Ces moyens de chargement CH comprennent aussi des portes OU3, OU4, OU5, OU6. Comme on le verra plus loin en détail, la porte OU3 reçoit des impulsions $CP_1$ provenant d'une horloge H, et reçoit, à l'initialisation, un signal CPINIT. Cette porte commande la chargement des bascules de l'ensemble P, à l'initialisation; elle intervient aussi dans la commande des différentes opérations de décalages. Sa sortie fournit le signal d'horloge CP1 à l'une des entrées des portes ET1...ET5. La porte OU4 commande les opérations de décalages dans le registre F. Elle reçoit d'une part le signal CPINIT et d'autre part le signal de sortie de la porte ET7 qui reçoit elle-même les signaux CP et $\overline{COMPT}$. QPO. La porte OU4 fournit un signal $CF_1$ qui commande les opérations de décalages dans le registre F, par l'intermédiaire du module de commande MC. Comme on le verra plus loin, cette porte commande aussi l'horloge H par l'intermédiaire des moyens A. La porte OU5 est une porte qui reçoit d'une part un signal RAZFINIT et, d'autre part, un signal provenant de la sortie de la porte ET8. Cette porte délivre un signal RAZF qui permet une remise à zéro du registre F, sur l'entrée RAZ de celui-ci. Enfin, la porte OU6, dont une entrée est reliée à la sortie de la porte OU4 et dont l'autre entrée peut recevoir un signal CFINIT, permet, lorsque l'on veut que le générateur démarre sur une combinaison quelconque, de commander les décalages dans le registre F de manière à commander l'apparition de cette combinaison, sur les sorties requises des bascules de l'ensemble de mémorisation P. Elle permet notamment de fixer le rang t.

Les moyens U qui provoquent la succession d'opérations de décalages entre les bascules de l'ensemble de mémorisation P, comprennent aussi des moyens Z qui sont constitués ici par une bascule PA de type D; cette bascule permet d'indiquer si une combinaison est présente sur les sorties des bascules de l'ensemble de mémorisation P et permet également de commander le démarrage des opérations de recherche d'une autre combinaison. Lorsqu'une combinaison est présente sur les sorties des bascules de l'ensemble de mémorisation P, un signal COMBINOK est fourni à la sortie d'un inverseur INV10; ce signal est en fait le signal $\overline{QPO}$, un signal QPO étant appliqué d'une part à l'entrée de l'inverseur INV10 et d'autre part, à l'entrée D de la bascule PA. L'entrée C de cette bascule reçoit, par l'intermédiaire de l'inverseur INV8 les impulsions CP de l'horloge H. La sortie de cette bascule est reliée à l'entrée d'une porte ET10 dont une autre entrée reçoit les impulsions d'horloge CP3, par l'intermédiaire des moyens de comptage A qui seront décrits plus loin en détail. L'entrée PR de la bascule PA reçoit un signal de commande "COMBIN SUIV" lorsque la combinaison suivante diot être recherchée, après une combinaison qui vient d'être affichée. Enfin, l'entrée CLEAR de la bascule PA, reçoit à l'initialisation du dispositif, le signal RAZPINIT. La bascule PA permet notamment de repérer la présence du niveau logique O sur la sortie QPO de la bascule PO, de manière à arrêter, par l'intermédiaire des moyens de comptage A, l'horloge H.

Les moyens de comptage A qui permettent d'arrêter la génération des combinaisons, comportent un compteur CPPO qui est chargé par un registre T à la valeur $N-1$, à chaque intialisation du rang t. Ce chargement est commandé par le signal RAZF qui est appliqué, au moment de l'initialisation au registre F, au compteur CPPO. Ce compteur comprend une autre entrée qui permet de décrémenter son contenu de une unité à chaque augmentation du rang t dans le registre F. Cette entrée porte la reférence-1 sur la figure et elle est reliée à la sortie de la porte OU4. Les opérations de décalages sont arrêtées lorsque le contenu du compteur CPPO est égal à O; Cet arrêt est commandé par le signal de sortie du compteur appliqué à un inverseur INV12; la sortie de cet inverseur est reliée à l'une des entrées d'une porte $ET_{16}$ dont l'autre entrée reçoit les impulsions $CP_2$ de l'horloge H. La sortie de cette porte est reliée à l'une des entrées de la porte ET10 dont l'autre entrée est reliée à la sortie de la bascule PA. Lorsque le contenu du compteur est égal à O, sa sortie passe au niveau 1 et vient bloquer la porte ET16 de manière à arrêter les opérations de décalages commandées par les impulsions d'horloge CP, qui agissent sur les moyens de contrôle X et sur les moyens de chargement CH. A l'initialisation du dispositif, la bascule PO est remise à zéro par l'intermédiaire du signal RAZQPO appliqué sur l'entrée CLEAR de cette bascule.

Le module MC permet de générer deux impulsions CF, à l'initialisation. Ces deux impulsions sont situées entre deux impulsions d'horloge $CP_1$, de façon à assurer un fonctionnement correct du générateur. La porte ET10 qui suit l'horloge H est en fait un circuit synchronisateur qui ne laisse passer l'impulsion d'horloge que si celle-ci est complète. Ceci évite de laisser passer des impulsions d'horloge, au cas où un signal COMBINOK de validation du démarrage des opérations de décalage, survient au cours d'une impulsion d'horloge $CP_1$. Cette portion d'impulsion peut en effet agir de façon incorrecte. La porte ET10 et ET16 particulières, peuvent être par exemple réalisées chacune à partir d'un circuit de synchronisation de type 74 120 commercialisé par la Société Texas Instruments. Ce synchronisateur représenté par la porte ET10 ne laisse passer des impulsions complètes que si et seulement si le signal de validation est à 1 au moment de la transition 0,1 de l'impulsion d'horloge.

Le principe de fonctionnement du générateur qui vient d'être décrit est le suivant: si l'on considère que N=5 et que p=3, la première combinaison disponible sur les sorties des bascules de l'ensemble de mémorisation P est la combinaison 11100. La sortie QP3 de la bascule P3 est au niveau 1 et il n'existe qu'une seule combinaison des deux niveaux 1 sur les bascules précédentes. Les combinaisons suivantes sont élaborées avec QP4=1, en balayant toutes les possibilités offertes sur les sorties des bascules de rang inférieur qui combinent deux niveaux 1. Ces possibilités sont au nombre de trois; il en résulte que trois combinaisons sont alors fournies sur les sorties des bascules QP1, QP2, QP3, lorsque QP4=1. Toutes les combinaisons disponibles sur les bascules de rang inférieur à 4 étant fournies, la sortie QP5 de la bascule P5 est alors au niveau logique 1 et le même processus recommence avec p=2 sur les quatre premières bascules qui fournissent ainsi 1+2+3=6 combinaisons. Il en résulte qu'au total dix combinaisons sont fournies sur les sorties du générateur lorsque N=5 et p=3. A chaque fois qu'en partant du rang 1, il existe des niveaux 1 sur des bascules successives du rang q jusqu'au rang r (avec $1 \leq q \leq r$) et des niveaux O sur toutes les bascules du rang 1 au rang $q-1$, (si $q-1 \geq 1$), cela correspond au fait que la bascule de rang r étant à un niveau 1, toutes les possibilités de balayage des combinaisons possibles des $r-1$ premières bascules, ont été passées en revue. Le passage à la combinaison suivante provoque alors une mise au niveau 1 de la bascule de rang r+1, une mise au niveau O de la bascule r et une réinitialisation ramenent tous les niveaux 1 successifs qui précèdent la bascule de rang r, sur les bascules successives à partir du rang 1. Ceci permet ensuite de balayer toutes les combinaisons pour les r premières bascules, en repartant du début. La bascule PO, dont la sortie QPO permet de ramener des O ou des 1 à l'entrée des bascules de l'ensemble P, par bouclage de la bascule $P_t$, agit de la manière suivante: la bascule $P_t$ choisie pour ce rebouclage, correspond à la bascule qui suit le premier niveau 1 de la suite de niveau 1 en cours de traitement; de cette manière lors des décalages successifs, si ce premier niveau 1 pousse un "UN" de la bascule suivanté", ce dernier est ramené sur la bascule PO et le O de la bascule PO contenu dans celle-ci au départ, est décalé d'un cran, tandis que le rang t augmente d'une unité. Cette opération est répétée jusqu'à ce que ce premier 1 "pousse" un zéro, c'est-à-dire jusqu'au moment où la bascule de rang immédiatement supérieur à p est atteinte par ce niveau 1; à cet instant, la sortie QPO de la bascule PO présente un niveau logique O, ce qui déclenche l'apparition du signal COMBINOK d'affichage de combinaison, sur la sortie de la bascule PA. On pourrait éventuellement dans une variante positionner le rang t pour que celui-ci corresponde au rang de la première bascule de niveau O suivant

un niveau 1 et faire des décalages jusqu'au rang t en rebouclant la bascule $P_t$ sur la bascule P1 jusqu'à ce que $P_{t-1}$ soit égal à O. Dans ce cas, la bascule PO serait supprimée et serait remplacée par un moyen qui permet de rechercher le positionnement de $P_t$ ainsi que par un moyen de lecture du contenu de la bascule $P_{t-1}$.

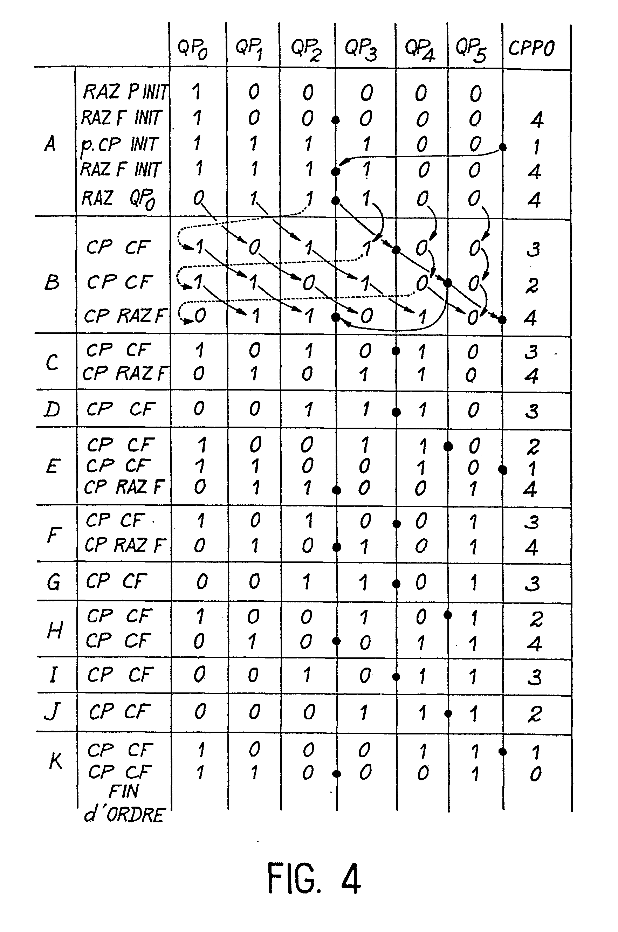

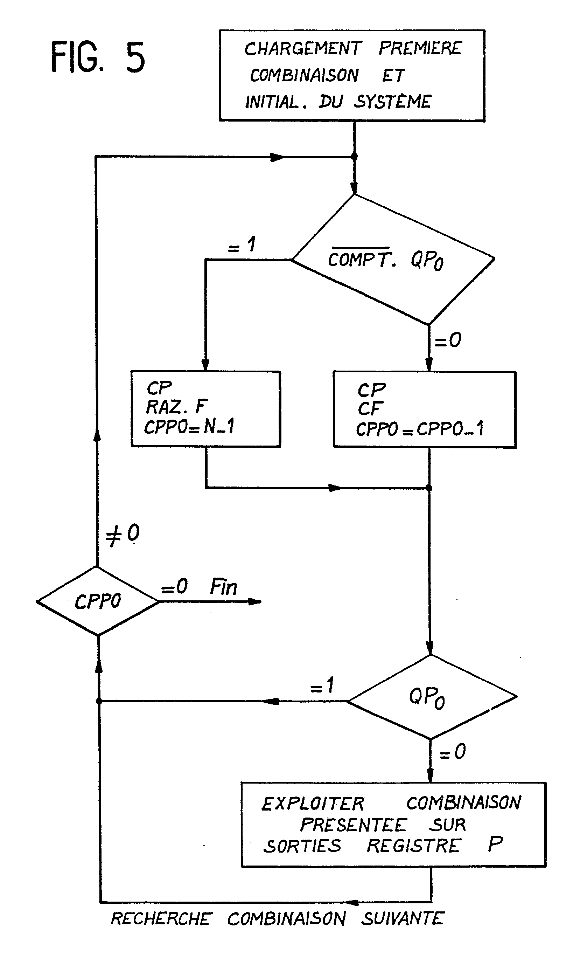

Le tableau de la figure 4 ainsi que l'organigramme de la figure 5 vont permettre maintenant de mieux comprendre le fonctionnement du générateur.

Dans le tableau de la figure 4, on a représenté les niveaux logiques sur les sorties QPO, QP1,...QP5, des bascules P1 à P5 du générateur de la figure 1. On a également représenté la valeur du contenu du compteur CPPO. La première colonne de ce tableau représente les principaux signaux qui interviennent au cours du fonctionnement du générateur. Ce tableau est subdivisé en cases A, B, C...J, K, qui représentent les contenus des différentes bascules de l'ensemble de mémorisation P ainsi que le contenu du compteur CPPO, au cours des différentes opérations de décalages, qui permettent de passer d'une combinaison à une autre. La dernière ligne de chaque case représente la combinaison de signaux logiques à un niveau 1 disponibles sur les sorties du générateur. Comme le montre l'organigramme de la figure 5, la première opération consiste à charger la première combinaison dans les bascules de l'ensemble de mémorisation P. Elle consiste aussi à initialiser le système. Pour charger cette première combinaison, une impulsion RAZPINIT met à zéro la bascule PA qui bloque les impulsions d'horloge CP, par l'intermédiaire de la porte ET10 de synchronisation. Cette impulsion parvient également à l'entrée PR de la bascule PO dont la sortie QPO passe au niveau 1; il en résulte qu'à la sortie de l'inverseur INV10, le signal COMBINOK est absent, indiquant qu'il n'y a pas actuellement de combinaison présente sur les sorties du registre P. L'impulsion RAZPINIT permet également de remettre à 0 toutes les bascules P ($P_1$ à $P_5$), ce qui est représenté sur la première ligne de la figure 5. Le signal suivant est le signal RAZFINIT. Ce signal met à zéro toutes les bascules du registre F et déclenche le circuit IF du module de commande MC pour initialiser au niveau logique 1 les sorties QF1 et QF2 du registre F, toutes les autres sorties (QF3...QF6 étant à zéro). Le compteur CPPO est chargé à la valeur N−1 (4 dans l'exemple considéré). Il en résulte qu'à la suite de cette opération, t=2; cette opération a principalement pour but de valider les décalages de niveaux logiques 1, issus de PO vers les bascules du registre P. La position du point montre cette validation jusqu'à la bascule P2 sur la 2ème ligne de la figure 4. Ensuite p impulsions (soit, 3 dans l'exemple) sont émises sur CPINIT de façon à ce que des 1 soient propagés jusqu'à la bascule P3 de l'ensemble P. Chaque impulsion CPINIT agit à travers la porte OU3 pour provoquer un décalage du registre P et à travers le OU4 pour provoquer un décalage du registre F de façon à autoriser la poursuite de la transmission des niveaux 1.

Ces opérations d'initialisation du registre F et des bascules de l'ensemble P, sont repérées par le signal CPINIT, dans le tableau de la figure 4. Après ces opérations, le compteur CPPO est chargé et contient la valeur N−1−p=5−1−3=1. Les opérations ci-dessus, déclenchées par les impulsions RAZFINIT et CPINIT, ne procurent pour l'instant, aucun résultat, car l'horloge est bloquée par la porte ET10. Dans l'exemple considéré, p=3 impulsions CPINIT ont été appliquées à la porte OU3 de manière à charger des niveaux logiques 1 dans les trois premières bascules de l'ensemble P. Chaque impulsion CPINIT réalise un décalage de l'état des bascules de l'ensemble P; l'impulsion CPINIT produit aussi un décalage dans l'état des bascules du registre F, qui se chargent ainsi avec des niveaux logiques 1 qui font progresser simultanément les autorisations de décalages entre les bascules de l'ensemble P. L'impulsion RAZFINIT appliquée à la porte OU5 permet de remettre à zéro le registre F grâce au signal de sortie RAZF de cette porte. Le signal RAZFINIT déclenche également le circuit IF qui permet de commander l'envoi de deux impulsions CF au registre F, sur son entrée de déclage DF, de manière à initialiser ce registre à t=2 (valeur qui correspond à l'affichage de la première combinaison). Cette impulsion RAZFINIT permet également de charger le compteur CPPO à la valeur N−1. Enfin, une impulsion RAZQPO est appliquée à l'entrée CLEAR de la porte PO. Cette impulsion remet à zéro la sortie QPO de la bascule PO; la remise à zéro de cette sortie permet, par l'intermédiaire de l'inverseur INV10 d'indiquer, grâce à un niveau logique 1 correspondant au signal COMBINOK présent sur cette sortie, qu'une combinaison de signaux logiques de niveau 1 est disponible sur les sorties QP1...QP5 du générateur. Les différentes opérations qui viennent d'être décrites sont celles qui sont indiquées dans la case A du tableau de la figure 4. A partir de cet instant, les combinaisons successives suivantes peuvent être recherchées.

A cet effet, une impulsion COMBIN SUIVANTE provenant de l'extérieur du générateur met à un niveau logique 1 la bascule PA qui permet de valider les impulsions d'horloge grâce à la porte ET10 de synchronisation. Si l'on désire présenter chaque combinaison pendant un temps, il est possible d'utiliser une première bascule monostable (non représentée) de période de conduction, déclenchée par la tansition 0,1 du signal COMBINOK; cette bascule monostable est connectée à une deuxième bascule monostable qui délivre une impulsion fine à la fin de la période de conduction de la première bascule monostable; cette impulsion fine est appliquée à l'entrée COMBIN SUIVANTE de la bascule PA.

Les fronts montants des impulsions d'horloge CP, qui sont transmises par la porte ET10 de synchronisation, permettent du réaliser les transferts de niveaux logiques de la bascule $P_t$ vers la bascule PO, et les décalages de PO vers P1 et des bascules Pi vers les bascules Pi+1, lorsque les signaux de sorties du registre F valident ces décalages. Le front descendant des impulsions d'horloge $CP_1$ transmet l'état de la sortie QPO de la bascule PO, à la bascule PA; celle-ci agit sur la porte ET10 de manière à bloquer l'horloge si QPO=0 (PA étant au niveau 0) ou à laisser transmettre les impulsions d'horloge si la bascule PA est au niveau 1 (QPO étant au niveau 1).

La bascule PA joue le rôle d'interface entre le générateur de combinaison et l'utilisateur. C'est ainsi que l'utilisateur sait qu'une combinaison est disponible quand la sortie COMBINOK de la bascule PA est au niveau 1. Cette combinaison est utilisée par exemple, pour injecter des défail-, lances sur un simulateur (pour faire une étude de fiabilité par exemple); quand le simulateur a fourni sa réponse, l'utilisateur envoie un signal "COMBIN SUIV" de façon à mettre à un niveau 1 la bascule PA, pour obtenir une remise en marche de l'horloge et une recherche de combinaison suivante. La bascule PA change d'état après la bascule PO, sur le front descendant de l'impulsion CP de l'horloge H, de façon à laisser à la bascule PO le temps d'atteindre son état. Les impulsions d'horloge doivent être suffisamment séparées pour laisser le temps à la bascule PA de bloquer l'horloge, dans le cas où QPO=O. L'impulsion COMBIN SUIV n'étant pas synchronisée avec l'horloge, la bascule PA permet de mémoriser cette impulsion jusqu'à ce que l'horloge soit à nouveau activée.

L'étape suivante représentée dans l'organigramme de la figure 5, consiste à tester la valeur $\overline{COMPT}$. QPO. Cette valeur est égale à 1, uniquement lorsque $QP_t$=O et QPO=1, c'est-à-dire qu'à la suite de l'impulsion d'horloge $CP_1$ suivante, la nouvelle combinaison peut être affichée puisque QPO sera égal à 0. Dans ce cas, l'impulsion d'horloge CP est validée par la porte ET10 de synchronisation et un signal RAZF est délivré par la porte ET8. Ce signal qui effectue une réinitialisation du registre F permet également de déclencher le chargement du compteur CPPO à la valeur N−1. Si par contre, la valeur $\overline{COMPT}$. QPO est égale à O, l'impulsion d'horloge traverse la porte ET10 et permet d'appliquer une impulsion CF au registre F, par l'intermédiaire des portes ET7 et OU4; cette impulsion CF permet également de décrémenter de une unité le contenu CPPO. Cette opération est représentée par CPPO=CPPO−1 dans l'organigramme de la figure 5. L'étape suivante consiste à tester l'état logique de la sortie QPO de la bascule PO, Si QPO=O, c'est que la combinaison est présente sur les sorties de l'ensemble de mémorisation P. Cette combinaison peut être exploitée et la combinaison suivante peut alors être recherchée en effectuant un certain nombre d'opérations de décalages dont le nombre est fixé par le contenu du compteur CPPO, sauf si le compteur CPPO a atteint la valeur 0. Si le contenu de CPPO est égal à O, c'est que toutes les combinaisons disponibles ont été balayées; si par contre, le contenu du compteur CPPO est différent de 0, c'est que la combinaison suivante peut être recherchée à partir de la combinaison qui vient d'être disponible. Si la sortie QPO de la bascule PO est au niveau logique 1, aucune combinaison n'est disponible sur les sorties des bascules de l'ensemble P, les opérations de décalage se déroulent comme indiqué précédemment, jusqu'à ce que PO soit au niveau logique 0, auquel cas une nouvelle combinaison est disponible, ou jusqu'à ce que le contenu de CPPO soit égal à 0, auquel cas la recherche des combinaisons est terminée.

Le compteur CPPO est chargé à chaque impulsion RAZF par le registre T qui contient la valeur N−1. Il est possible, au lieu d'utiliser un registre contenant la nombre N−1, d'utiliser un système de roues codeuses qui affiche ce nombre sur la face avant du générateur ou de tout autre système équivalent. Lorsque ce compteur atteint le chiffre 0, sa sortie passe au niveau logique 1, ce qui arrête la propagation des impulsions d'horloge $CP_2$ et bloque la recherche de combinaisons. Lorsque le contenu de ce compteur est différent de 0, sa sortie est au niveau logique 0.

Dans le fonctionnement du générateur qui vient d'être décrit, on a supposé que toutes les combinaisons étaient affichées en suivant la combinaison initiale, visible sur la première ligne du tableau de la figure 2. Il est également possible d'afficher toutes les combinaisons à partir d'une combinaison prédéterminée. Dans ce cas, les portes ET9 ou OU6 servent à charger, d'une part, les bascules de l'ensemble de mémorisation P, et d'autre part, le registre F par les niveaux logiques correspondant respectivement à la combinaison choisie, et à la valeur de p qui fixe le rang de la bascule qui suit immédiatement la première bascule au niveau logique 1, dans la séquence choisie. Le chargement du registre P s'effectue de la façon suivante: une impulsion RAZPINIT permet de remettre à zéro le registre P et de mettre la bascule PO au niveau logique 1. Une impulsion RAZFINIT est appliquée pour initialiser le registre F de sorte que t=2 et pour autoriser les décalages des niveaux logiques entre les bascules des registres P. Des impulsions CPINIT sont appliquées à la porte OU3, tandis que la porte ET9, dont une entrée est reliée à la sortie QPO de la bascule PO, reçoit sur son entrée $P_1$INIT, des niveaux 1 ou des niveaux 0 successifs, correspondant à la combinaison désirée au départ. Ces niveaux envoyées sur l'entrée P1 INIT sont bien entendu combinées avec les impulsions CPINIT, de manière à obtenir sur les sorties des bascules de l'ensemble de mémorisation P, la combinaison désirée de niveau logique 1. Les bascules de cet ensemble étant positionnées, il s'agit alors de positionner le registre F à la valeur de t connue lors de l'initialisation, du fait de la connaissance de la combinaison injectée, qui fixe le rang de la bascule de l'ensemble de mémorisation qui suit immédiatement la première bascule à un niveau 1, dans la séquence choisie. Pour positionner le registre F à la valeur t, une impulsion RAZFINIT est appliquée au registre F pour effectuer sa réinitialisation à t=2 et des impulsions CFINIT sont ensuite appliquées à l'entrée de la porte OU6, en nombre égal à t−2.

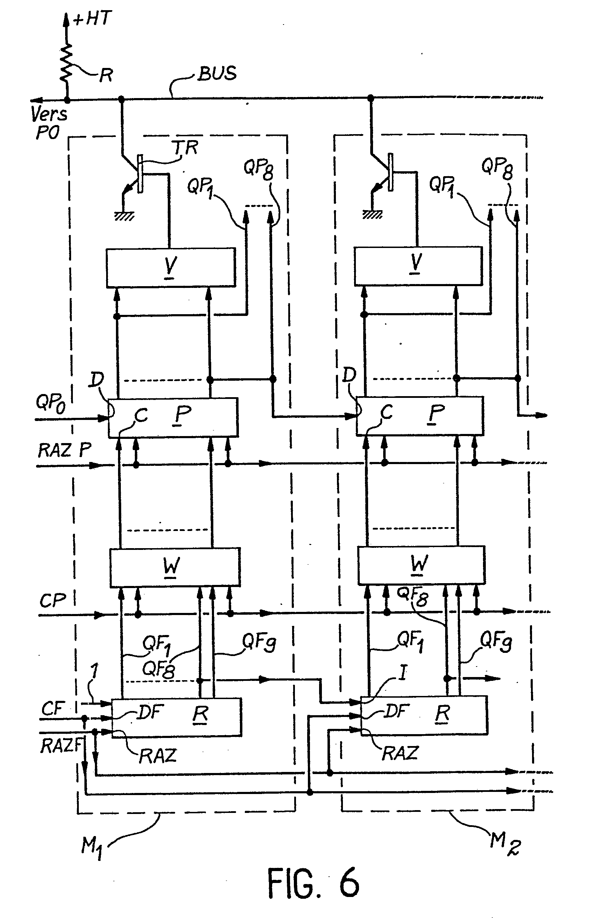

La figure 6 représente schématiquement le générateur de l'invention dans le cas où celui-ci est construit sous forme modulaire. Dans ce mode de réalisation, les bascules de l'ensemble P, les moyens V de report de l'état de la bascule $P_t$ vers la bascule PO, forment un module. Le générateur comporte une pluralité de ces modules, connectés en cascades, de sorte que la sortie de la dernière bascule d'un ensemble P de mémorisation d'un module, soit reliée à l'entrée de la première bascule de l'ensemble P de mémorisation du module suivant. La sortie de la dernière bascule des moyens de repérage R d'un module est elle aussi reliée à l'entrée de la première bascule du moyen de repérage du module suivant. Chaque sortie des portes OU des moyens V de report de niveau logique de sortie de la bascule $P_t$ vers l'entrée de la bascule PO, est reliée à l'entrée D de la bascule PO, par un transistor monté en "collecteur ouvert". La sortie QPO de la bascule PO est reliée à l'entrée de la première bascule de l'ensemble de mémorisation P du premier module. Les bascules des moyens de mémorisation des ensembles P des modules et les bascules des moyens R de repérage d'initialisation des modules, sont reliées aux moyens de chargement CH. Sur la figure 6, on n'a représenté que deux de ces modules M1 et M2 et on a supposé que chacun d'eux contient un ensemble de mémorisation P constitué de huit bascules dont les sorties sont représentées en QP1...QP8. Dans chaque module les moyens correspondants R de repérage et d'initialisation du rang t, comprennent dans cet exemple de réalisation neuf bascules dont les sorties ont été représentées en QF1...QF9; enfin, chaque module, comprend aussi les moyens correspondants V de report d'état de la bascule $P_t$ de ce module vers la bascule PO (non représentée sur cette figure). Enfin, chaque module comporte les moyens W de commande des décalages. Ces moyens comprennent notamment, dans l'exemple décrit et pour chaque module, huit portes ET (non représentées) dont les sorties sont reliées aux entrées C des bascules de l'ensemble de mémorisation P de chaque module. Le deuxième module M2 est contitué de la même manière et ne sera pas décrit en détail. La première bascule de l'ensemble de mémorisation P du premier module reçoit sur son entrée D, le signal QPO provenant de la porte PO, tandis que la dernière sortie QP8 de la dernière bascule de l'ensemble P du premier module est reliée à l'entrée D de la première bascule de l'ensemble P du second module. Les modules successifs suivants sont reliés entre eux de la même manière. Toutes les bascules des ensembles de mémorisation P des modules successifs reçoivent le signal RAZP. Les moyens de commande W des opérations de décalages entre les bascules de chaque ensemble de mémorisation P reçoivent les impulsions d'horloge CP1. Enfin, les bascules F des moyens de repérage R reçoivent les impulsions de décalages CF, ainsi que les impulsions de remise à zéro RAZF. On n'a pas représenté sur cette figure, les autres moyens appartenant au générateur de l'invention et qui émettent les signaux mentionnés plus haut; ces moyens ont été décrits précédemment et sont communs à tous les modules. Les moyens V qui fournissent le signal COMPT qui permet de reporter l'état de la bascule $P_t$ vers la bascule PO sont reliés à cette bascule par une ligne BUS commune. Les moyens V de chaque module sont reliés à cette ligne par l'intermédiaire d'un transistor TR monté en collecteur ouvert ou d'un circuit équivalent. Ce transistor de type NPN a sa base qui est reliée, par exemple, à la sortie des moyens V (il remplace l'inverseur INV6 de la figure 1 par exemple). L'émetteur de ce transistor est relié à la masse M; son collecteur est relié à la ligne BUS et à une source positive de tension+HT, par l'intermédiaire d'une résistance R commune à tous les transistors montés en collecteurs ouverts à la sortie de chacun des modules. Il est bien évident que ce transistor monté en collecteur ouvert et qui a été représenté ici à la sortie des moyens V, pourrait évidemment être inclus dans l'inverseur 6 de la figure 1, par exemple. La sortie QF8 des moyens de repérage R d'un module, est reliée à l'entrée I de la première bascule des moyens R suivants; cette entrée I correspond à l'entrée qui, dans la première bascule du registre F du premier module, est portée au niveau logique 1. Ainsi, la dernière bascule d'un ensemble de mémorisation P d'un module transmet son état logique à la première bascule de l'ensemble de mémorisation P du module suivant; l'avant dernière bascule du registre F du moyen de repérage R d'un module transmet son état logique à la première bascule du registre F des moyens de repérage R du module suivant. Ce type de montage modulaire a pour avantage de diminuer le nombre des connexions de commande lorsque le nombre des bascules devient important; enfin, les transistors en "collecteur ouvert" qui relient les sorties des moyens V de repérage des bascules $P_t$, permettent de transmettre vers la bascule PO, le signal COMPT provenant de l'un des modules, sans provoquer de courtcircuit sur les sorties semblables des autres modules. Ce transistor se comporte en fait comme un interrupteur qui se ferme uniquement lorsqu'un signal COMPT est disponible sur la sortie d'un module. Il est bien évident que le générateur qui a été décrit n'est pas limité au nombre de sorties iniqué en exemple.

Une variante non représentée consiste à n'utiliser que 8 bascules QF1...QF8 pour le registre F et à rejouter une connexion provenant de la sortie QF1 du module M2 vers le module M1 pour remplacer le signal QF9. Dans la variante précédente la bascule QF9 était au même niveau logique que la bascule QF1 du module suivant. L'intérêt résulte de la suppression d'une liaison entre les modules.

Le générateur qui vient d'être décrit peut également comporter un circuit logique de blocage constitué par exemple par une porte ET17 et par une porte OU7. Ce circuit logique permet de bloquer la génération des combinaisons, à partir d'une combinaison prédéterminée. A cet effet, les entrées de la porte ET17 sont respectivement reliées, par des liaisons non représentées sur la figure, à des sorties des moyens de mémorisation P qui correspondent aux sorties qui fournissent cette combinaison prédéterminée. C'est ainsi par exemple, que dans l'exemple de réalisation décrit, le générateur permet de réaliser des combinaisons de niveaux logiques 1 sur trois sorties; la porte ET17 présente trois entrées qui sont respectivement reliées aux trois sorties des moyens de mémorisation P, qui correspondent à une combinaison prédéterminée au-delà de laquelle on désire arrêter le générateur. La sortie de la porte ET17 est reliée à une entrée de la porte OU7, dont une autre entrée est reliée à la sortie du compteur CPPO des moyens d'arrêt A. Lorsque les trois entrées de la porte ET17 sont à un niveau logique 1, la sortie de la porte ET17 est à un niveau logique 1, et la porte OU7 dont la sortie est au niveau logique 1, vient bloquer la porte ET16, et donc bloquer l'horloge H.

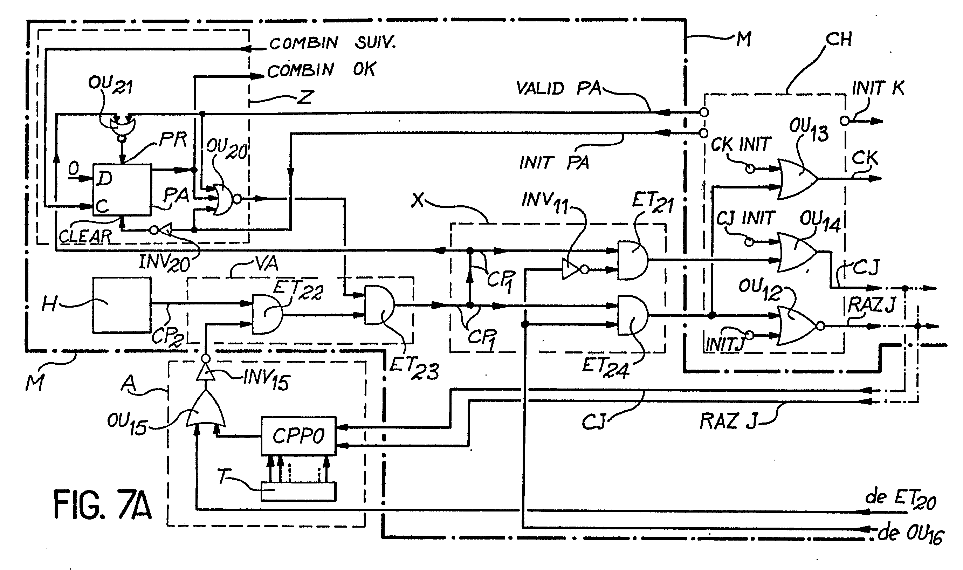

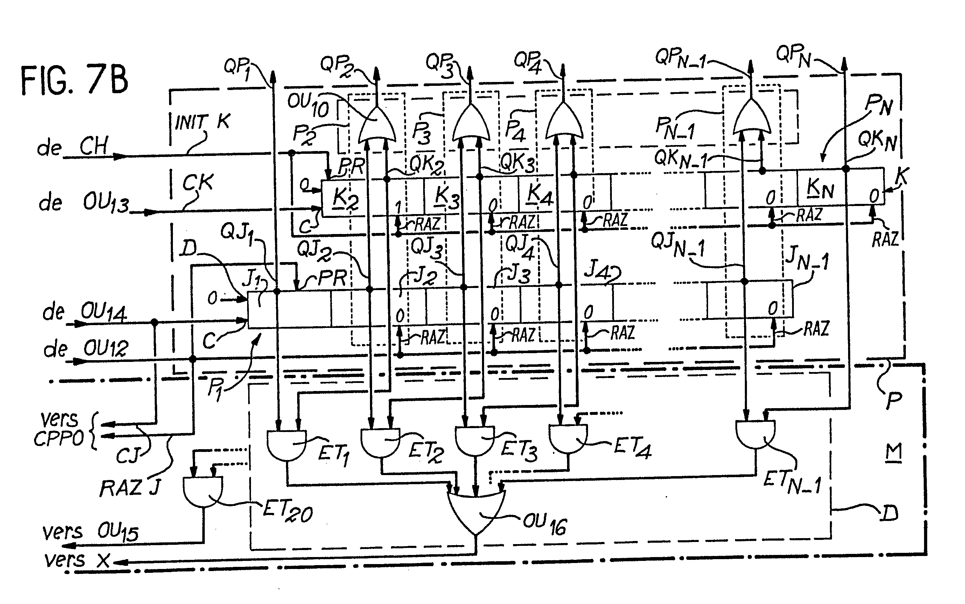

Les figures 7A et 7B représentent un autre mode de réalisation du générateur de combinaisons de l'invention. Selon cet autre mode de réalisation, le générateur permet de former les combinaisons de $p=2$ sorties au niveau logique 1 et de $N-p$ sorties au niveau logique 0, parmi les N sorties $QP_1$, $QP_2$,...$QP_N$ du générateur. Dans ce mode de réalisation, l'ensemble P des N moyens de mémorisation $P_1$, $P_2$,...$P_N$ comprend un groupe de deux registres à décalage J, K, constitués respectivement par $N-1$ bascules ($J_1$, $J_2$...$J_{N-1}$), ($K_2$, $K_3$...$K_N$). Les sorties $QJ_1$, $QJ_2$,...$QJ_{N-1}$ du premier registre J sont repérées de 1 à $N-1$, tandis que les sorties $QK_2$, $QK_3$,...$QK_{N-2}$ du deuxième registre K sont repérées de 2 à N. La première sortie $QP_1$ des moyens de mémorisation P, est constituée par la sortie $QJ_1$ de la première bascule $J_1$ du premier registre J, tandis que la dernière sortie QPN des moyens de mémorisation P, est constituée par la sortie QKN de la dernière bascule KN du deuxième registre K. L'ensemble de mémorisation P comprend en outre un ensemble E de $N-2$ portes OU à deux entrées. Les deux entrées de ces portes sont respectivement connectées aux sorties ($QJ_2$, $QK_2$), ($QJ_3$, $QK_3$),...($QJ_{N-1}$, $QK_{N-1}$); correspondantes des bascules de même rang ($J_2$, $K_2$), ($J_3$, $K_3$)...($J_{N-1}$, $K_{N-1}$) des registres J et K. C'est ainsi par exemple que la première porte OU10 de l'ensemble E, présente deux entrées qui sont respectivement reliées aux sorties $QJ_2$ et $QK_2$ des registres J et K. Comme la première sortie du registre J et la dernière sortie du registre K constituent également les première et dernière sorties de l'ensemble P de mémorisation, l'ensemble E comprend $N-2$ portes OU. Les sorties de ces portes constituent respectivement les sorties $QP_2$, $QP_3$...$QP_{N-1}$ des moyens de mémorisation P. Dans ce mode de réalisation, le générateur comprend également des moyens de chargement CH qui appliquent des signaux d'initialisation INITK, CKINIT, CJINIT, INITJ, de remise à zéro RAZJ et de décalage CK, CJ, sur des entrées correspondantes des registres J, K. Les moyens de commande M sont reliés aux sorties $QJ_1$, $QJ_2$, $QK_2$...$QJ_{N-1}$, $QK_N$ des registres à décalage J, K, pour commander la génération des combinaisons, par l'intermédiaire des moyens de chargement CH et des moyens d'arrêt A, comme on le verra plus loin en détail.

Les moyens de commande M comprennent des moyens de détection D dont les entrées sont reliées respectivement aux sorties des registres à décalage J, K, pour détecter si une bascule de rang j du premier registre J et une bascule de rang $k=j+1$ du deuxième registre K, sont à un niveau 1 (j pouvant varier de 1 à $N-1$ et k et 2 à N). Les moyens M comprennent également des moyens de contrôle X, dont une entrée de commande C est reliée à une sortie des moyens de détection D. Des sorties de ces moyens de contrôle X sont reliées à des entrées de commande des moyens de chargement CH pour commander les décalages dans les registres J et K. Ces moyens de commande CH interviennent de deux façons: ils commandent soit un décalage d'un rang du contenu du premier registre J, si les moyens de détection D n'ont pas déecté deux niveaux 1 successifs sur les sorties de rang j et k successives des bascules de registre J et K. Ils permettent également de commander un décalage d'un rang du contenu du deuxième registre K et une réinitialisation du contenu du premier registre J, de façon que la sortie $QJ_1$ de la première bascule $J_1$ du premier registre J soit à un niveau 1, et que les autres sorties $QJ_2$, $QJ_3$,...$QJ_{N-1}$, de rang 2 à $N-1$ de ce premier registre J, soient au niveau 0. Les moyens M comprennent aussi des moyens Z qui permettent d'indiquer par un signal COMBINOK, qu'une combinaison est présente sur les sorties $QP_1$, $QP_2$,...$QP_N$ des moyens de mémorisation P. Ces moyens permettent également, comme on le verra par la suite, de commander, par un signal COMBINSUIV, la recherche d'une autre combinaison. Les moyens Z d'indication de présence de combinaisons et de commande de recherche d'une autre combinaison, reçoivent sur des entrées des signaux d'initialisation INITPA et de validation VALIDPA, comme on le verra plus loin en détail. Une sortie de ces moyens Z fournit un signal COMBINOK indiquant la présence d'une combinaison disponible sur les sorties des moyens de mémorisation P. Une autre sortie de ces moyens Z est reliée à une entrée d'un circuit de validation VA; ce circuit valide les opérations qu'effectuent les moyens de chargement CH à partir des impulsions d'une horloge H dont la sortie est reliée à une autre entrée des moyens de validation VA. Les moyens d'arrêt A présentent une sortie qui est reliée à une autre entrée des moyens de validation VA, pour bloquer ces moyens de validation, lorsque les combinaisons désirées auront été obtenues. Les moyens d'arrêt A reçoivent, comme on le verra par la suite, des signaux de remise à zéro RAZJ et de commande de décalage CJ qui sont aussi appliqués au premier registre J.

Les moyens de détection D sont constituées par un ensemble de $N-1$ portes $ET_1$, $ET_2$,...$ET_{N-1}$, repérés de 1 à $N-1$. Les entrées de chacune de ces portes sont respectivement reliées à la sortie de la bascule de même rang du registre J et à la sortie de la bascule de rang immédiatement supérieur du registre K. C'est ainsi par exemple que la porte $ET_1$ présente deux entrées qui sont respectivement reliées aux sorties $QJ_1$ du registre J et $QK_2$ du registre K. L'ensemble de détection D comprend aussi une porte OU16 dont les entrées sont respectivement reliées aux sorties des portes ET de cet ensemble de détection; la sortie de cette porte est reliée à l'entrée de commande C des moyens de contrôle X.

Les moyens d'arrêt A sont constituée notamment par un compteur CPPO chargé à la valeur $N-2$, à chaque initialisation du premier registre J. Ce compteur décompte d'une unité à chaque décalage du contenu de ce premier registre J.

Enfin, le générateur comprend un circuit logique de blocage de génération des combinaisons, constitué par exemple par le porte ET20 dont la sortie est reliée à un amplificateur-inverseur INV15 des moyens d'arrêt A. La sortie de cet amplificateur-inverseur est reliée à une entrée d'une porte OU12 dont une autre entrée est reliée à la sortie du compteur CPPO des moyens d'arrêt A. Dans le cas où le générateur permet d'obtenir toutes les combinaisons des sorties présentant un niveau logique 1, parmi les N sorties du générateur, la porte ET20 présente deux entrées qui sont reliées respectivement à deux sorties prédéterminées de l'ensemble de mémorisation P, correspondant à une combinaison prédéterminée de signaux logiques à un niveau 1. Lorsque cette combinaison est atteinte, la porte ET20 permet d'arrêter la génération des combinaisons en bloquant l'horloge H par l'intermédiaire de l'inverseur INV15 et de la porte OU12.

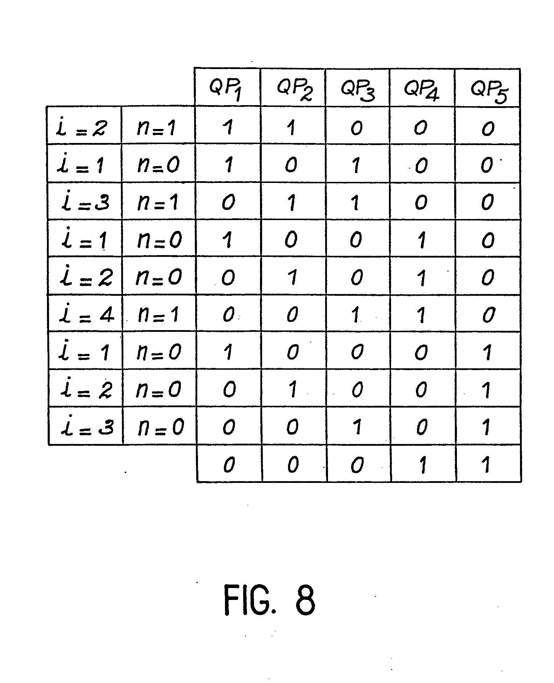

La figure 8 est un tableau qui donne toutes les combinaisons de $p=2$ signaux logiques à un niveau 1, sur les cinq sorties d'un générateur conforme au second mode de réalisation de l'invention. On suppose qu'au départ, ce sont les deux premières sorties $QP_1$, $QP_2$, du générateur, qui présentent un niveau logique 1, alors que les sorties restantes $QP_3$, $QP_4$, $QP_5$, présentent un niveau logique 0. Ces états logiques sont représentés sur la première ligne du tableau. Comme on l'a mentionné dans le premier mode de réalisation de l'invention, les moyens M permettent de repérer le moyen de mémorisation $P_i$ qui est défini comme étant un moyen dont la sortie est au niveau logique 1 et qui est immédiatement suivi par le moyen de mémorisation $P_{i+1}$ dont la sortie est au niveau logique 0, i étant le plus faible possible. Sur la première ligne du tableau de la figure 8, le moyen de mémorisation $P_i$ est la bascule $P_2$ (i=2), tandis que le moyen de mémorisation $P_{i+1}$ est la bascule $P_3$. En effet, la bascule $P_2$ dont la sortie $QP_2$ est au niveau logique 1, est immédiatement suivie de la bascule $P_3$ dont la sortie $QP_3$ est au niveau logique 0. Le rang i est toujours le plus faible possible, les moyens M permettant de détecter la première transition 1,0 sur les sorties QP des bascules de l'ensemble P. Les moyens M permettent de ramener, sur tous les moyens de mémorisation qui précèdent le moyen $P_i$ ($P_2$ dans l'exemple considéré), une succession de niveaux logiques 1 en commençant par le moyen de mémorisation $P_1$ jusqu'au moyen de mémorisation de rang N inclus; n est égal au nombre de niveaux 1 qui existent sur les moyens de mémorisation qui précèdent le moyen $P_i$. Dans l'exemple considéré, le moyen de mémorisation $P_1$ qui précède le moyen $P_2$, présente déjà une sortie qui est au niveau logique 1. Cette sortie ne change donc pas d'état logique. Les moyens de commande M permettent aussi de remplacer l'état du moyen de mémorisation $P_i$, par un niveau logique 0 et l'état du moyen de mémorisation $P_{i+1}$ à un niveau logique 1. Dans l'exemple représenté sur le tableau de la figure 8, et à la deuxième ligne de ce tableau, on voit que le niveau logique 1 de la bascule $P_2$ a été remplacé par un niveau logique 0, tandis que le niveau logique 0 de la bascule $P_3$ a été remplacé par un niveau logique 1. Les bascules qui suivent la bascule $P_{i+1}$ ($P_4$, $P_5$, dans l'exemple considéré-2ème ligne du tableau), ne changent pas d'état.

La deuxième ligne du tableau présente la deuxième combinaison de sorties ($QP_1$, $QP_3$) du générateur, qui présentent un niveau logique 1, les trois sorties restantes $QP_2$, $QP_4$, $QP_5$, étant au niveau logique 0. Pour cette deuxième combinaison, i=1 et n=0.

Comme on l'a mentionné plus haut, les moyens M permettent de compléter la succession de niveaux logiques 1 qui ont été ramenés sur les bascules qui précèdent la bascule $P_i$, par des niveaux logiques 0 ramenés sur toutes les bascules qui suivent la bascule de rang n et qui précèdent la bascule de rang i. C'est ainsi, par exemple, que pour passer de la troisième à la quatrième combinaison, sur les sorties du générateur (représentées sur les troisième et quatrième lignes du tableau de la figure 8), on part de i=3 et n=1 (3ème combinaison). Le moyen M fait passer la bascule $P_4$ à l'état logique 1, la bascule $P_3$ à l'état logique 0, ramène des niveaux 1 sur les bascules qui précèdent la bascule $P_3$, excepté sur la bascule $P_2$ qui est ramenée à l'état logique 0, puisque c'est la seule bascule de rang n=2 qui est située entre les bascules de rang i=3 et i=1. La quatrième combinaison est alors disponible sur les sorties $QP_1$ et $QP_4$ du générateur. Les autres combinaisons disponibles sur les sorties du générateur des figures 7A et 7B sont représentées sur les différentes lignes du tableau de la figure 8; elles sont obtenues comme décrit plus haut. Comme précédemment, on a supposé dans ce tableau que la combinaison prédéterminée de départ est celle qui permet d'obtenir des niveaux 1, sur les sorties des premières bascules ($P_1$, $P_2$) de l'ensemble de mémorisation P; il est bien évident que cette première combinaison prédéterminée de départ pourrait être l'une quelconque de celles qui sont représentées sur les lignes du tableau de la figure 8.

Dans le second mode de réalisation, le générateur, représenté sur les figures 7A et 7B, fonctionne de la manière suivante: on trouve dans le registre K, un seul niveau 1 et dans le registre J un seul niveau 1; la bascule du registre J qui contient un niveau 1 présente un rang qui est inférieur au rang de la bascule du registre K qui contient un niveau 1. Le générateur est initialisé par les signaux INITJ et INITK fournis par les moyens de chargement CH; les bascules des registres J et K étant des bascules de type D, décrites plus haut, le signal INITK est appliqué à l'entrée PR de la première bascule $K_2$ du registre K ainsi qu'aux entrées de remise à zéro RAZ des bascules de rangs successifs suivants $K_3,...K_N$. L'entrée D de la première bascule $K_2$ de ce registre est portée au niveau logique 0. Il en résulte qu'à l'initialisation, la bascule $K_2$ est au niveau logique 1, tandis que toutes les autres bascules du registre K sont au niveau logique 0. Le signal INITJ est appliqué à la porte OU12, par les moyens de chargement CH; cette porte fournit un signal RAZJ, d'une part à l'entrée PR de la première bascule $J_1$ du registre J et, d'autre part, aux entrées de remise à zéro RAZ des bascules de rang successifs suivants $J_2...J_{n-1}$ du registre J. L'entrée D de la première bascule $J_1$ de ce registre est portée au niveau logique 0. Il en résulte qu'à l'initialisation, la première bascule $J_1$ du registre J est au niveau logique 1, tandis que toutes les autres bascules $J_2...J_{n-1}$ de ce registre, sont au niveau logique 0. C'est ainsi que les sorties $QP_1$ et $QP_2$ de l'ensemble de mémorisation P sont au niveau logique 1, tandis que toutes les autres sorties $QP_3...QP_n$ sont au niveau logique 0. Cette combinaison est donc la première combinaison de signaux logiques à un niveau 1, fournie par le générateur.

Les moyens de détection D détectent alors que le niveau logique 1 dans la bascule $K_2$ du registre K, suit immédiatement le niveau logique 1 de la bascule $J_1$, du registre J. Cette détection provoque alors la recherche de la combinaison suivante: il est effectué une réinitialisation du registre J de manière que la bascule $J_1$ soit au niveau 1 et que les autres bascules $J_2...J_{n-1}$ de ce registre soient au niveau logique 0; cette détection provoque également un décalage du contenu du registre K, par application sur l'entrée C de ce registre, d'une impulsion CK fournie, comme on le verra par la suite, par une porte OU13 des moyens de chargement CH. Il en résulte, qu'après ces opérations, les sorties $QP_1$ et $QP_3$ des moyens de mémorisation P sont à un niveau logique 1, tandis que les autres sorties sont au niveau logique 0. C'est donc la deuxième combinaison qui est disponible sur les sorties de l'ensemble de mémorisation, après les opérations qui viennent d'être décrites. La combinaison suivante est obtenue en décalant d'un rang le contenu du registre J, par une impulsion CJ appliquée à l'entrée C de la première bascule de ce registre;

cette impulsion est fournie par une porte OU14 des moyens de chargement CH. En effet, les moyens de détection D, après la combinaison 10100 précédemment obtenue, ($QP_1=1$, $QP_2=0$, $QP_3=1$, $QP_4=0$, $QP_5=0$) détectent l'absence de deux niveaux 1 successifs sur les sorties des bascules des registres J, K. Cette absence se traduit par un signal de niveau logique 0 sur la sortie de la porte OU16 de l'ensemble de détection D. Ce niveau logique 0 est appliqué à l'entrée d'un amplificateur-inverseur INV11 des moyens de contrôle X. La sortie de cet inverseur est reliée à l'une des entrées d'une porte ET21 de ces moyens de contrôle; une autre entrée de cette porte reçoit des impulsions d'horloge $CP_1$ provenant d'une sortie des moyens de validation VA. Ces moyens de validation sont constitués par des portes ET22 et ET23; une entrée de la porte ET22 est reliée à la sortie de l'horloge H qui fournit des impulsions $CP_2$. Il en résulte que la porte ET21 fournit à sa sortie des impulsions d'horloge qui sont appliquées à la porte OU14 qui délivre les impulsions de décalage CJ. Les impulsions de décalage CK du contenu du registre K sont obtenues de la même manière, à partir des impulsions d'horloge $CP_1$ appliquées à l'une des entrées de la porte ET24 des moyens de contrôle X; cette porte présente une autre entrée qui est reliée à la sortie des moyens de détection D et qui est portée à un niveau logique 1 lorsque des niveaux logiques 1 successifs sont disponibles sur les sorties des bascules des registres J et K. La sortie de cette porte ET24 est reliée à l'une des entrées de la porte OU13 qui délivre les impulsions de décalage CK.

En résumé, à chaque fois que des niveaux logiques 1 se suivent sur les sorties des bascules des registres J et K, on réinitialise le registre J et on décale le contenu du registre K, tandis que si les niveaux 1 disponibles sur les sorties des registres J et K ne se suivent pas, on décale simplement le contenu du registre J en lui appliquant des impulsions CJ de décalage.

Il est possible d'initialiser le générateur, à partir d'une combinaison prédéterminée de départ; dans ce cas des niveaux logiques 1 sont propagés dans les registres par l'application de signaux INITJ et INITK de niveau logique 1, sur les entrées C des premières bascules des registres J et K. Ces signaux placent un niveau 1 unique dans le registre J et un niveau 1 dans le registre K; leur application est suivie d'une application d'impulsions CJINIT, CKINIT qui permettent de propager ces niveaux logiques 1 dans des bascules prédéterminées des registres J et K. Les moyens d'arrêt A sont constitués, comme dans le premier mode de réalisation, par un compteur CPPO qui reçoit, d'une part le signal de commande de réinitialisation RAZJ du registre à décalage J et d'autre part, des impulsions de commande de décalage CJ du contenu de ce registre. Ce compteur est chargé à la valeur N−2, à l'initialisation et à chaque fois qu'un signal INITJ est appliqué à l'entrée de la porte OU12 qui fournit le signal RAZJ. Il est chargé à la valeur N−2, par un registre T et il décompte d'une unité à chaque décalage du contenu du registre J, c'est-à-dire à chaque fois qu'une impulsion CJ est appliquée à ce registre. Lorsque le contenu de ce compteur est à zéro, ce compteur bloque les impulsions $CP_2$ de l'horloge H, par l'intermédiaire de l'inverseur INV15 qui applique un niveau logique 0 sur l'une des entrées de la porte ET22. Ce blocage de l'horloge entraîne l'arrêt de la génération des combinaisons; comme on l'a mentionné précédemment, ce blocage peut être réalisé par l'intermédiaire de la porte ET20 et de la porte OU15, dans le case où l'on désire arrêter la génération des combinaisons, à partir d'une combinaison prédéterminée.

Lorsque le générateur qui vient d'être décrit fonctionne à partir de la première combinaison disponible, c'est-à-dire à partir de la combinaison pour laquelle les sorties $QP_1$ et $QP_2$ des moyens de mémorisation P sont à un niveau logique 1, alors que toutes les autres sorties $QP_3...QP_n$ sont à un niveau logique 0, d'indication de recherche de combinaisons, un signal INITPA au niveau logique 1, qui est maintenu pour bloquer l'horloge. Comme dans le mode de réalisation précédent, ces moyens d'indication de recherche de combinaison comprennent une bascule PA de type D dont l'entrée D est au niveau logique 0. Le signal INITPA est appliqué à l'entrée CLEAR de la bascule PA, par l'intermédiaire d'un inverseur INV20 appartenant aux moyens Z. Il en résulte que la bascule PA met à zéro le signal COMBINOK, pour indiquer que la combinaison n'est pas présente. Le signal INIT PA réalise aussi le blocage de l'horloge H par l'intermédiaire de la porte OU20 dont le signal de sortie est inversé, avant d'être appliqué à la porte ET23. La porte OU20 reçoit également le signal de sortie de la bascule PA et le signal VALIDPA; ensuite, les moyens de chargement CH fournissent les signaux INITJ et INITK qui permettent d'initialiser les contenus des registres J et K. Enfin, les moyens de chargement CH appliquent le signal VALIDPA et suppriment le signal INITPA pendant la durée du signal VALIDPA, de façon à mettre à 1 le signal COMBINOK, pour indiquer que la première combinaison est présente sur les sorties des moeyns de mémorisation P. Le signal VALIDPA est appliqué sur l'entrée PR de la bascule PA, par l'intermédiaire d'une porte OU21 à sortie inversée, appartenant aux moyens Z.

Un signal COMBINSUIV est fourni à la bascule PA pour procéder à la recherche de la combinaison suivante. La bascule PA permet alors de valider l'application des impulsions d'horloge $CP_1$, aux moyens de contrôle X, par l'intermédiaire de la porte ET23 des moyens de validation VA. Ces impulsions sont également appliquées à la porte OU21. Cette impulsion d'horloge $CP_1$ déclenche, par l'intermédiaire des moyens de contrôle X, l'une des opérations suivantes: soit un décalage du contenu du registre J si les moyens de détection D n'ont pas détecté de niveaux 1 successifs sur les sorties des bascules des registres J et K, soit un décalage du contenu du registre K et une réinitialisation du contenu du registre J, de façon que le niveau logique de la sortie $QJ_1$ de la première bascule $J_1$ du registre J, soit égal à 1 et que le niveau logique des sorties $QJ_2...QJ_{n-1}$ des bascules suivantes de ce registre, soit égal à 0. L'impulsion $CP_1$ déclenche alors avec un certain retard, la mise à 1 du signal COMBINOK pour indiquer qu'une combinaison est présente. Le processus recommence alors de la même manière avec l'application du siognal COMBINSUIV. Les moyens d'arrêt A qui comprennent le compteur CPPO chargé à la valeur N−2 par le registre T, au moment où le signal RAZJ lui est appliqué, décomptent à chaque impulsion CJ qu'ils reçoivent. Lorsque le contenu de ce compteur est égal à 0, l'horloge H est bloquée par l'intermédiaire de l'inverseur INV15 et de la porte ET22: la dernière combinaison est présente sur les sorties des moyens de mémorisation P. Les portes ET22 et ET23 sont en fait constituées à partir de circuits synchronisateurs (de type 74120, mentionné plus haut), de façon à ne laisser passer que des impulsions d'horloge entières.

En résumé, lorsque le générateur de combinaison des figures 7A et 7B doit fournir des combinaisons, à partir de la première combinaison, les moyens Z d'indication et de commande de démarrage, interviennent de la manière suivante:

— Les moyens de chargement CH émettent le signal INIT PA qui met à zéro l'information COMBIN OK pour indiquer que la combinaison n'est pas présentée. INIT PA est maintenu au niveau 1 de façon à bloquer l'horloge H par l'intermédiaire de la porte ET23.

— Les moyens CH fournissent les signaux INIT K puis INIT J suivis de CJ INIT, comme indiqué précédemment.

— Les moyens CH fournissent VALID PA qui met à 1 l'information COMBIN OK, pour indiquer que la 1ère combinaison est présente. INIT PA est alors remis à zéro avant la fin de l'impulsion VALID PA de façon à permettre la mise à 1 de la bascule PA par le signal VALID PA. VALID PA bloque l'horloge H pour permettre à la bascule PA de basculer entre la fin de INIT PA et la fin de VALID PA. Lorsque la bascule PA est passée à 1, l'horloge H est alors bloquée et reste bloquée par le signal COMBIN OK.

— Le signal COMBIN SUIV est alors appliqué à la bascule PA pour indiquer qu'il faut procéder à la recherche de la combinaison suivante.

— La bascule PA valide alors l'horloge H qui émet une impulsion $CP_1$. (ET22 et ET23 étant des portes de type décrit plus haut).

— Cette impulsion $CP_1$ déclenche par l'intermédiaire des moyens de contrôle X, la recherche de la combinaison suivante en opérant,

— soit un transfert de K dans J et mise à 0 de J1 et décalage de K si J1=1.

— soit un décalage de J vers les rangs les plus faibles si J1=0.

Cette impulsion $CP_1$ déclenche aussi après un certain retard la mise à 1 du signal COMBIN OK pour indiquer que la combinaison est présente.

— Le processus recommence avec le signal COMBIN SUIV.

Les moyens d'arrêt A comprennent un compteur CPPO qui est chargé à N−2 qui est décompté à chaque impulsion CJ; lorsque le contenu du compteur CPPO atteint 0, les moyens A bloquent l'horloge car la dernière combinaison est présente.

Lorsque le générateur doit générer des combinaisons, à partir d'une combinaison prédéterminée, son fonctionnement est le suivant: les moyens de contrôle CH appliquent à la bascule PA, le signal INITPA et le maintiennent au niveau 1, puis appliquent aux registres J et K les signaux INITJ et INITK. Ensuite, ces moyens fournissent des impulsions CJINIT et CKINIT, pour positionner respectivement les niveaux 1 de poids le plus faible et de poids le plus fort dans les bascules correspondantes des registres J et K. Les moyens de contrôle CH appliquent alors le signal VALIDPA à la bascule PA de manière à faire apparaître à la sortie de cette bascule le signal COMBINOK indiquant la présence d'une combinaison. A partir de cet instant, les combinaisons suivantes sont générées à chaque fois que la bascule PA des moyens Z, reçoit un signal COMBINSUIV.

Comme dans le mode de réalisation précédent, le générateur peut être réalisé sous forme modulaire. Dans ce cas, il comprend un pluralité de groupes de registres à décalage J, K, reliés en série, une pluralité d'ensembles E de portes OU à deux entrées, associées respectivement au groupe de registres à décalage J, K, ainsi qu'une pluralité de moyens de détection D associés respectivement au groupe de registres à décalage J, K. Chaque module est formé par un groupe de registres J, K, ainsi que par les moyens de détection D et par l'ensemble E des portes OU qui correspondent à ce groupe de registres. Les sorties des ensembles E des portes OU sont reliées à l'entrée de commande C des moyens de contrôle X, par l'intermédiaire d'un transistor monté en collecteur ouvert, tel que décrit dans le premier mode de réalisation du générateur de l'invention.

**Revendications**

1. Générateur de signaux logiques combinés pour former des combinaisons de p sorties au niveau logique 1 et N−p sorties au niveau logique 0 parmi N sorties (QP1,...QPN) du générateur sur lesquelles sont disponibles les p signaux logiques de niveau 1 et les N−p signaux logiques de niveau 0, N et p étant des constantes, caractérisé en ce qu'il comprend:

— un ensemble (P) de N moyens de mémorisation (P1, P2,...PN), ces moyens de mémorisation étant repérés du rang 1 au rang N, les combinaisons des p sorties au niveau 1 et N−p sorties au niveau 0 étant fournies sur les sorties (QP1,...QPN) de ces moyens de mémorisation de rangs 1 à N;

— des moyens (CH) pour charger dans les moyens de mémorisation (P1, P2,...PN), les niveaux logiques correspondant à une combinaison prédéterminée de départ;

— des moyens de commande (M) pour repérer le moyen de mémorisation Pi qui est défini comme étant un moyen dont la sortie est au niveau logique 1 et qui est immédiatement suivi par le moyen de mémorisation $P_{i+1}$ dont la sortie est au niveau logique 0, le rang i étant le plus faible possible, les moyens M permettant de ramener, sur tous les moyens de mémorisation qui précèdent éventuellement le moyen $P_i$, une succession de niveaux logiques 1, en commençant par le moyen de mémorisation de rang 1 jusqu'au moyen den rang n inclus, n étant égal au nombre de niveaux 1 existant sur les moyens de mémorisation précédant le moyen Pi, succession compltétée éventuellement de niveaux 0 après le moyen de mémorisation de rang n et avant le moyen de rang i, les moyens de commande (M) permettant aussi de remplacer l'état du moyen de mémorisation Pi par un niveau 0 et l'état du moyen de mémorisation Pi+1 par un niveau 1, les moyens de mémorisation de rang supérieur à i+1 ne changeant pas d'état, l'application répétée du moyen de commande M fournissant les combinaisons qui suivent la combinaison prédéterminée de départ;

— des moyens (A) pour arrêter la génération des combinaisons après une autre combinaison prédéterminée.

2. Générateur selon la revendication 1, caractérisé en ce que ladite combinaison prédéterminée de départ est, soit la première combinaison pour laquelle les niveaux logiques 1 sont disponibles sur les sorties des p premiers moyens de mémorisation $(P_1, P_2...P_p)$, les sorties des N−p moyens de mémorisation suivants $(P_{p+1}, P_{p+2}...P_N)$ étant au niveau logique 0, soit toute autre combinaison prédéterminée de niveaux logiques 1 disponibles sur les sorties de p moyens de mémorisation.

3. Générateur de combinaison selon la revendication 2, caractérisé en ce que les moyens de commande (M) comprennent:

— des moyens R pour repérer le rang t d'un certain moyen de mémorisation Pt et faire évoluer le rang t, ces moyens R étant reliés aux moyens de chargement CH pour initialiser $t$ à une valeur telle que le moyen de mémorisation Pt correspondant soit celui qui suit le premier moyen de mémorisation dont la sortie est au niveau logique 1, lorsque la combinaison est disponible sur les sorties QP1 à QPN;

— un moyen de mémorisation PQ dont la sortie est QPO;

— des moyens U pour provoquer une succession d'une ou plusieurs opérations de décalages entre les moyens de mémorisation de l'ensemble (P), jusqu'à ce que l'état de la sortie QPO du moyen de mémorisation PO soit au niveau 0, chaque opération réalisant des décalages simultanés de l'état du moyen de mémorisation PO, vers le moyen de mémorisation P1 et de chacun des moyens Pj de rang j, vers le moyen suivant Pj+1 de rang j+1, pour tous les moyens Pj dont le rang est compris entre 1 et t−1, les moyens Pk de rang k ne changeant pas d'état pour tous les moyens de mémorisation Pk de rang k supérieur à t, le moyen de mémorisation PO étant chargé par l'état de la sortie du moyen Pt de rang t, au cours de cette opération de décalage, chaque opération provoquant aussi, soit une réinitialisation de la limite t des moyens de repérage et d'initialisation (R) à condition que la sortie du moyen de mémorisation Pt, soit au niveau 0 en même temps que l'état du moyen PO est au niveau 1, soit une augmentation d'une unité du rang t correspondant à la limite de repérage des moyens (R), si cette dernière condition n'est pas satisfaite, cette évolution du rang t étant conditionnée par l'état de la sortie des moyens PO et Pt avant décalage, le nouveau rang t ne devenant efficace qu'après décalage, l'application des moyens U fournissant les combinaisons successives dont la présence est déterminée par un niveau 0 sur la sortie de la bascule QPO, les moyens U comprenant un moyen V qui permet de reporter l'état de la bascule Pt vers l'entrée de la bascule PO, les moyens (R) de repérage, d'initialisation et d'évolution du rang t, étant constitués par un registre à décalage (F) à N+1 bascules numérotées 1 à N+1, ce registre étant chargé par t niveaux 1 sur les t premières bascules et par N−t+1 niveaux 0 sur les bascules suivantes, les N+1 sorties (QP1, QP2,...QFN+1 du registre F servant à valider ou non les décalages et à sélectionner la bascule Pt en détectant la transition 1,0 sur le registre F pour reporter l'état de la bascule Pt vers le moyen PO, QF1 validant le transfert entre PO et P1, QF2 validant le transfert entre P1 et P2,...,QFN validant le transfert entre PN−1 et PN et QFN+1 détectant la transition 1,0 quelle que soit la valeur de N.

4. Générateur selon la revendication 3, caractérisé en ce que les moyens de mémorisation (P1, P2...PN) de l'ensemble P sont constitués par un registre unique à décalage à N bascules.

5. Générateur selon la revendication 3, caractérisé en ce que les moyens (R) de repérage et d'initialisation comprennent en outre des moyens pour initialiser F de sorte que t=2.

6. Générateur selon la revendication 5, caractérisé en ce que le moyen V permettant de reporter l'état de la bascule Pt vers l'entrée de la bascule PO, comprend, pour chacune des bascules de l'ensemble P, une porte ET dont une entrée est reliée à la sortie QPb de la bascule Pb correspondante, pour b compris entre 1 et N, les autres entrées de cette porte étant reliées respectivement à la sortie QFb de même rang de la bascule Fb du registre F et à la sortie QFb+1 de la bascule Fb+1, de rang immédiatement supérieur, le niveau logique de la sortie de la bascule Pt n'étant reporté vers l'entrée de là bascule PO que si la sortie QFb correspondante du registre F est au niveau 1 et si la sortie QFb+1 de rang directement supérieur est au niveau 0, les moyens V comprenant en outre une porte OU dont les entrées sont reliées aux sorties des portes ET, la sortie de cette porte OU transmettant à la bascule PO, la seule information correspondant au niveau logique de la sortie de la bascule Pt et qui a été détecté par la transition de niveaux 1,0 sur les niveaux logiques de sorties du registre F, les moyens U qui provoquent la succession de décalage comprennent en outre des moyens W reliés aux entrées de commande de décalages des bascules de l'ensemble de mémorisation P et aux sorties du registre à décalage F reliées elles-mêmes aux moyens V, pour commander les opérations de décalages entre les bascules de l'ensemble P, et un moyen de contrôle X relié d'une part aux moyens W de commande des opérations de décalages entre les bascules de l'ensemble P et d'autre part, à la sortie QPO de la bascule PO, ce moyen X permettant, soit de réinitialiser la limite t de repérage du moyen de repérage et d'initialisation R, soit d'augmenter de une unité le rang de cette limite.

7. Générateur selon la revendication 5, caractérisé en ce que le moyen V permettant de reporter le niveau logique de la sortie de la bascule Pt vers l'entrée de la bascule PO, comporte, pour chacune des bascules de l'ensemble P, une porte ET dont une entrée est reliée à la sortie QPb de la bascule Pb correspondante, pour b compris entre 1 et N, les autres entrées de cette porte étant reliées respectivement aux sorties QPb−1 et QPb−2 des bascules Pb−1 et Pb−2 de l'ensemble P et à la sortie QFb de la bascule Fb de même rang du registre F, le niveau logique à la sortie de la bascule Pt n'étant reporté vers l'entrée de la bascule PO que si la sortie QFb correspondante du registre F est au niveau 1 et si QPb=1, QPb−1=1 et QPb−2=0, les moyens V comportant en outre une porte OU dont les entrées sont reliées aux sorties des portes ET, la sortie de cette porte OU transmettant à la bascule PO, la seule information correspondant au niveau logique de la sortie de la bascule Pt et qui a été détectée en correspondance avec la transition 1,0 sur les niveaux logiques de sorties du registre F, les moyens U qui provoquent la succession de décalages comprennent en outre des moyens W reliés au moyen V et aux entrées de commande du décalages des bascules de l'ensemble de mémorisation P et aux sorties du registre à décalage F, pour commander les opérations de décalages entre les bascules de l'ensemble P, et un moyen de contrôle X relié d'une part aux moyens W de commande des opérations de décalages entre les bascules de l'ensemble P et d'autre part, à la sortie QPO de la bascule PO, ce moyen X permettant, soit de réinitialiser la limite t de repérage du moyen de repérage et d'initialisation R, soit d'augmenter de une unité le rang de cette limite.

8. Générateur selon l'une quelconque des revendications 6 et 7, caractérisé en ce que les moyens W de commande de décalages sont constitués par un circuit logique provoquant, par l'intermédiaire des moyens de chargement (CH) et du moyen de contrôle (X) des décalages simultanés de l'état du moyen de mémorisation PO vers le moyen P1 et de chacun des moyens Pj, vers le moyen suivant Pj+1 pour tous les moyens Pj dont le rang est compris entre 1 et t−1, les moyens Pk ne changeant pas d'état pour tous les moyens de mémorisation Pk de rang supérieur à t, le moyen de mémorisation PO étant chargé par l'état du moyen Pt de rang t au cours de cette opération de décalage, le moyen de contrôle X du moyen de repérage R, commandant, par des niveaux logiques correspondant à une combinaison prédéterminée sur certains moyens de mémorisation, les décalages entre les bascules du registre F par l'intermédiaire des moyens CH de chargement des moyens de mémorisation P, les moyens U qui provoquent une succession d'opérations de décalages entre les bascules de l'ensemble P comprenant en outre des moyens Z reliés au moyen de mémorisation PO pour indiquer qu'une combinaison est présente sur les sorties des moyens de mémorisation de l'ensemble P ou pour commander le démarrage des opérations de recherche d'une autre combinaison, ces moyens Z d'indication et de commande de démarrage étant en outre connectés à la sortie d'une horloge H de commande des différentes opérations de décalages et à la sortie QPO de la bascule PO afin de repérer la présence du niveau logique 0 sur la sortie QPO, de manière à arrêter l'horloge et indiquer la présence d'une combinaison disponible sur p sorties de l'ensemble P, ou de manière à redémarrer l'horloge pour la recherche d'une autre combinaison, cette horloge commandant les opérations de décalage par l'intermédiaire des moeyns A d'arrêt de génération de combinaison, des moyens de contrôle X et des moyens C de chargement des bascules de l'ensemble P, les moyens A d'arrêts de génération de combinaisons comportant un compteur CPPO chargé à la valeur N−1 par les moyens de chargement (CH), à l'initialisation du rang t déterminé par les moyens d'initialisation et de repérage R, ce compteur étant activé à chaque augmentation d'une unité du rang t, de manière que les opérations de décalages soient arrêtées lorsque son contenu atteint 0, ce moyen de comptage comportant de plus une porte ET reliée à la sortie du compteur et à la sortie de l'horloge, la sortie de cette porte commandant les opérations de décalages par l'intermédiaire des moyens de contrôle X et des moyens CH de chargement des bascules de l'ensemble P.

9. Générateur selon l'une quelconque des revendications 6 à 8, caractérisé en ce que les registres F des moyens R, les bascules de l'ensemble P, les moyens V de report de l'état de la bascule Pt vers la bascule PO, forment un module, le générateur comportant une pluralité de ces modules connectés en cascade, de sorte que la sortie de la dernière bascule d'un ensemble P d'un module, soit reliée à l'entrée de la première bascule de l'ensemble P du module suivant, la sortie de la dernière bascule des moeyns de repérage R d'un module étant reliée à l'entrée de la première bascule du moyen de repérage du module suivant, chaque sortie des portes OU des moyens V de report du niveau logique de la sortie de la bascule Pt vers l'entrée de la bascule PO, étant reliée à cette entrée par un transistor monté en "collecteur ouvert", la sortie QPO de la bascule PO étant reliée à l'entrée de la première bascule de l'ensemble P du premier module, les bascules des moyens de mémorisation des ensembles P des modules et les bascules des moyens R de repérage et d'initialisation des modules étant reliées aux moyens de chargement (CH).

10. Générateur selon la revendication 9, caractérisé en ce qu'il comprend en outre un circuit logique (ET17, OU7) de blocage de génération des combinaisons, à partir d'une combinaison prédéterminée, ce circuit logique présentant des entrées reliées à des sorties des moyens de mémorisation (P) qui correspondent aux sorties fournissant ladite combinaison prédéterminée, et une sortie de commande de blocage de l'horloge (H).

11. Générateur selon l'une quelconque des revendications 1 et 2, caractérisé en ce que, pour former les combinaisons de p=2 sorties au niveau logique 1 et N−p sorties au niveau logique 0, parmi les N sorties (QP1...QPN) du générateur l'ensemble P des N moyens de mémorisation (P₁...Pₙ) comprend un groupe de deux registres à décalage (J, K) constitués respectivement par N−1 bascules (J1,...JN−1, K2,...KN), les sorties (QJ1...QJN−1) du premier registre J étant repérées de 1 à N−1 et les sorties (QK2...QKN) du deuxième registre K étant repérées de 2 à N, la première sortie (QP1) des moyens de mémorisation P étant constituée par la sortie (QJ1) de la première bascule (J1) du premier registre (J) et la dernière sortie (QPN) des moyens de mémorisation P étant constituée par la sortie (QKN) de la dernière bascule (KN) du deuxième registre (K), l'ensemble de mémorisation (P) comprenant en outre un ensemble (E) de N−2 portes OU à deux entrées, les deux entrées de ces portes OU étant respectivement connectées aux sorties (QJ2, QK2, QJ3, QK3...QJN−1, QKN−1) correspondantes des bascules de même rang (J2, K2, J3, K3...JN−1, KN−1) des registres (J, K), les sorties de ces portes OU constituant respectivement les sorties (QP2...QPN−1) des moyens de mémorisation P, les moyens de chargement (CH) appliquant des signaux d'initialisation, de remise à zéro et de décalage sur des entrées correspondantes des registres (J, K) et les moyens (M) de commande étant reliés aux sorties des registres à décalage (J, K) pour commander la génération des combinaisons, par l'intermédiaire des moyens de chargement (CH) et des moyens d'arrêt (A), le moyen M comprenant des moyens (D) dont les entrées sont reliées respectivement aux sorties des registres à décalage (J, K) pour détecter si une bascule de rang j du premier registre (J) et une bascule de rang K=j+1 du deuxième registre (K) sont à un niveau 1, j pouvant varier de 1 à N−1 et K de 2 à N, des moyens de contrôle (X) dont une entrée de commande est reliée à une sortie des moyens de détection (D) et dont des sorties sont reliées à des entrées de commande des moyens de chargement (CH) pour déclencher, soit un décalage d'un rang du contenu du premier registre (J) si les moyens de détection (D) n'ont pas détecté deux niveaux 1 successifs sur les sorties de rang j et k successifs de deux bascules des deux registres (J, K), soit un décalage d'un rang du contenu du deuxième registre (K) et une réinitialisation du contenu du premier registre (J), de façon que la sortie (QJ1) de la première bascule (J1) du premier registre (J) soit à un niveau 1 et que les autres sorties (QJ2...QJN−1) de rang 2 à N−1 de ce premier registre (J) soient au niveau 0, des moyens (Z) pour indiquer qu'une combinaison est présente sur les sorties (QP1...QPN) des moyens de mémorisation (P) ou pour commander la recherche d'une autre combinaison, ces moyens (Z) d'indication et de commande de recherche de combinaison recevant sur des entrées des signaux d'initialisation, de validation ou de commande de recherche d'une autre combinaison, une sortie de ces moyens fournissant un signal indicateur de présence d'une combinaison sur les sorties des moyens de mémorisation (P), une autre sortie de ces moyens étant reliée à une entrée d'un circuit de validation (VA) des opérations effectuées par les moyens de chargement (CH) à partir des impulsions d'une horloge (H) dont la sortie est reliée à une autre entrée des moyens de validation (VA), les moyens d'arrêt (A) présentant une sortie que est reliée à une autre entrée des moyens de validation (VA) pour bloquer ces moyens de validation lorsque les combinaisons désirées ont été obtenues, ces moyens d'arrêt (A) recevant sur des entrées, les signaux de remise à zéro et de commande de décalage, appliqués au premier registre (J), les moyens de détection (D) étant constitués par N−1 portes ET à deux entrées, ces portes étant repérées de 1 à N−1, les entrées de chaque porte étant respectivement reliées à la sortie de la bascule de même rang du registre J et à la sortie de la bascule de rang immédiatement supérieur du registre K, les sorties de ces portes ET étant reliées aux entrées d'une porte OU dont la sortie est reliée à l'entrée de commande des moyens de contrôle (X), les moyens d'arrêt (A) étant constitués par un compteur chargé à la valeur N−2 à chaque initialisation du premier registre (J), ce compteur décomptant d'une unité à chaque décalage du contenu de ce premier registre (J).

12. Générateur selon la revendication 11, caractérisé en ce qu'il comprend en outre un circuit logique de blocage de génération de combinaisons, à partir d'une combinaison prédéterminée, ce circuit logique présentant des entrées reliées à des sorties des moyens de mémorisation (P) correspondant aux sorties fournissant ladite combinaison prédéterminée, et une sortie de commande de blocage de l'horloge (H).

13. Générateur selon la revendication 12, caractérisé en ce qu'il comprend une pluralité de groupes de registres à décalage (J, K) reliés en série, une pluralité d'ensembles de portes OU à deux entrées, associées respectivement aux groupes de registres à décalage (J et K), et une pluralité de moyens de détection (D), associés respectivement aux groupes de registres à décalage (J, K), un groupe de registres (J, K) ainsi que les moyens de détection (D) et l'ensemble de portes OU qui correspondent à ce groupe formant un module, les sorties des ensembles portes OU des moyens de détection (D) étant reliées à l'entrée de commande (C) des moyens de contrôle (X), par l'intermédiaire d'un transistor monté en collecteur ouvert.

**Patentansprüche**

1. Generator für kombinierte logische Signale zum Bilden von Kombinationen aus p Ausgängen des logischen Pegels 1 und N−p Ausgängen des logischen Pegels 0 under N Ausgängen (QP1,...QPN) des Generators, an denen die p logischen Signale des Pegels 1 und die N−p logischen Signale des Pegels 0 zur Verfügung stehen, wobei N und p Konstanten sind, dadurch gekennzeichnet, daß er enthält:

— eine Anordnung (P) aus N Speichern (P1, P2,...PN), die mit den Rängen 1 bis N bezeichnet sind, und an deren Ausgängen (QP1,...QPN) die Kombinationen der p Ausgänge des Pegels 1 und die N−p Ausgänge des Pegels 0 erscheinen;
— Einrichtungen (CH) zum Eingeben von logischen Pegeln, die einer von Anfang an vorbestimmten Kombination entsprechen, in die Speicher (P1, P2,...PN);
— Steuereinrichtungen (M), um denjenigen Speicher $P_i$ zu markieren, der als solcher definiert ist, dessen Ausgang einen logischen Pegel 1 hat und dem unmittelbar der Speicher $P_{i+1}$ folgt, dessen Ausgang den logischen Pegel 0 hat, wobei der Rang i der kleinstmögliche ist, die Steuereinrichtungen (M) es zulassen, an allen Speichern, die dem Speicher $P_i$ gegebenenfalls verangehen, eine Folge logischer Pegel 1 zurückzustellen, beginnend beim Speicher des Ranges 1 und reichend bis zum Speicher vom Rang n einschließlich, wobei n gleich der Zahl der Pegel 1 ist, der an den Speichern, die dem Speicher $P_i$ vorangehen, herrscht, die Folge gegebenenfalls vor dem Speicher vom Rang n und nach dem Speicher vom Rang i mit Pegeln 0 vervollständigt wird, die Steuereinrichtungen (M) auch zulassen, den Zustand des Speichers $P_i$ durch einen Pegel 0 zu ersetzen und den Zustand des Speichers $P_{i+1}$ durch einen Pegel 1 zu ersetzen, wobei die Speicher von höherem Rang als $i+1$ den Zustand nicht ändern, die wiederholte Einwirkung der Steuereinrichtungen (M) die Kombinationen liefern, die der von Anfang an vorbestimmten Kombination folgen;

— Einrichtungen (A) zum Abbrechen der Erzeugung von Kombinationen nach einer weiteren vorbestimmten Kombination.

2. Generator nach Anspruch 1, dadurch gekennzeichnet, daß die genannte, von Anfang an vorbestimmte Kombination entweder die erste Kombination ist, für die die logischen Pegel 1 an den Ausgängen der p ersten Speicher ($P_1$, $P_2$...$P_p$) zur Verfügung stehen, wobei die Ausgänge der $N-p$ nachfolgenden Speicher ($P_{p+1}$, $P_{p+2}$...$P_N$) den logischen Pegel 0 haben, oder jede andere vorbestimmte Kombination vom logischen Pegel 1 ist, die an den Ausgängen der p Speicher zur Verfügung stehen.

3. Kombinationsgenerator nach Anspruch 2, dadurch gekennzeichnet, daß die Steuereinrichtungen (M) enthalten:

— Einrichtungen (R), um den Rang t eines gewissen Speichers Pt zu markieren und den Rang t weiterentwickeln zu lassen, die mit den Eingebeeinrichtungen CH verbunden sind, um t anfänglich auf einen solchen Wert einzustellen, daß der zugehörige Speicher Pt jenem entspricht, der dem ersten Speicher folgt, dessen Ausgang den logischen Pegel 1 hat, wenn die Kombination an den Ausgängen QP1 bis QPN zur Verfügung steht;

— einen Speicher PO, dessen Ausgang QPO ist;

— Einrichtungen U zum Hervorrufen einer Folge von einer oder mehreren Verschiebeoperationen zwischen den Speichern der Anordnung (P), bis der Zustand des Ausgangs QPO des Speichers PO den Pegel 0 hat, wobei jede Operation simultane Verschiebungen des Zustandes des Speichers PO auf den Speicher P1 und von jedem der Speicher Pj vom Rang j gegen den nachfolgenden Speicher Pj+1 vom Rang j+1 für alle Speicher Pj bewirkt, deren Rang zwischen 1 und $t-1$ liegt, wobei die Speicher Pk vom Rang k den Zustand an allen Speichern Pk vom Rang k größer als t nicht ändern, der Speicher PO mit dem Zustand des Ausgangs des Speichers Pt vom Rang t im Lauf dieser Verschiebeoperation geladen wird, wobei jede Operation entweder eine Reinitialisierung des Grenzwertes t der Einrichtungen (R) zum Markieren und Initialisieren im Falle, daß der Ausgang des Speichers Pt den Pegel 0 hat und gleichzeitig der Zustand des Speichers PO auf dem Pegel 1 ist, oder eine Erhöhung im eine Einheit des Ranges t entsprechend dem Grenzwert der Markierungseinrichtungen (R) hervorruft, wenn die lietztgenannte Bedingung nicht erfüllt ist, wobei diese Weiterentwicklung des Ranges t vom Zustand des Ausgangs der Speicher PO und Pt vor dem Verschieben bedingt ist, der neue Rang t erst nach der Verschiebung wirksam wird, die Wirkung der Einrichtungen U die nachfolgenden Kombinationen liefern, deren Anwesenheit von einem Pegel 0 am Ausgang des Flipflops QPO bestimmt ist, die Einrichtungen U eine Einrichtung V enthalten, die es erlaubt, den Zustand des Flipflops Pt dem Eingang des Flipflops PO zu übermitteln, die Einrichtungen (R) zum Markieren, zum Initialisieren und zum Weiterentwickeln des Ranges t von einem Schieberegister (F) mit $N+1$ Flipflops, die mit 1 bis $N+1$ numeriert sind, das mit t Pegeln 1 an den ersten t Flipflops und mit $N-t+1$ Pegeln 0 an den folgenden Flipflops geladen wird, die $N+1$ Ausgänge (QF1, QF2,...$Q_{FN+1}$) des Registers F dazu dienen, die Verschiebungen freizugeben oder nicht und das Flipflop Pt auszuwählen, indem der 1/0-Übergang am Register F detektiert wird, um den Zustand des Flipflops Pt dem Speicher PO mitzuteilen, QF1 die Übertragung zwischen PO und P1 freigibt, QF2 die Übertragung zwischen P1 und P2 freigibt ...$Q_{FN}$ die Übertragung zwischen $P_{N-1}$ und $P_N$ freigibt und QFN+1 den 1/0-Übergang unabhängig von der Größe von N detektiert.

4. Generator nach Anspruch 3, dadurch gekennzeichnet, daß die Speicher ($P_1$, $P_2$...$P_N$) der Anordnung P von einem einzigen Schieberegister mit N Flipflops gebildet sind.

5. Generator nach Anspruch 3, dadurch gekennzeichnet, daß die Einrichtungen (R) zum Markieren und Initialisieren weiterhin Initialisierungseinrichtungen F aufweisen derart, daß t=2 ist.

6. Generator nach Anspruch 5, dadurch gekennzeichnet, daß die Einrichtung V, der die Übertragung des Zustandes des Flipflops Pt an den Eingang des Flipflops PO zuläßt, weiterhin für jedes der Flipflops der Anordnung P eine UND-Schaltung aufweist, deren Eingang mit dem Ausgang QPb des entsprechenden Flipflops Pb verbunden ist, wobei b zwischen 1 und N liegt, die anderen Eingänge dieser Torschaltung entsprechend mit dem Ausgang $QF_b$ desselben Ranges des Flipflops $F_b$ des Registers F und dem Ausgang $QF_{b+1}$ des Flipflops Fb+1 des unmittelbar höheren Ranges verbunden sind, der logische Pegel des Ausgangs des Flipflops $P_t$ dem Eingang des Flipflops PO nur dann übertragen wird, wenn der entsprechende Ausgang QFb des Registers F den Pegel 1 hat und wenn der Ausgang QFb+1 des unmittelbar höheren Ranges den Pegel 0 hat, die Einrichtungen V weiterhin eine ODER-Schaltung enthält, deren Eingänge mit den Ausgängen der UND-Schaltungen verbunden sind und deren Ausgang an das Flipflop PO die einzige Information überträgt, die dem logischen Pegel des Ausgangs des Flipflops $P_t$ entspricht und die durch den 1/0-Pegelübergang an den logischen Pegeln der Ausgänge des Registers F detektiert worden ist, die Einrichtungen U, die die Verschiebungsfolge hervorrufen, weiterhin Einrichtungen W aufweisen, die mit den Schiebesteuereingängen der Flipflops der Speicheranordnung P und mit den Ausgängen des Schieberegisters F verbunden sind, die ihrerseits mit den Einrichtungen V verbunden sind, um die Verschiebungen zwischen den Flipflops der Anordnung P zu steuern, und eine Steuereinrichtung X, die einerseits mit den Steuereinrichtungen W für die Verschiebung zwischen den Flipflops der Anordnung P und andererseits mit dem Ausgang QPO des Flipflops PO verbunden ist, wobei die Einrichtung X entweder die Reinitialisierung des Markierungsgrenzwertes t der Einrichtung R zum Markieren und Initialisieren oder die Erhöhung des Rangs dieses Grenzwerts um eine Einheit zuläßt.

7. Generator nach Anspruch 5, dadurch gekennzeichnet, daß die Einrichtung V, die die Übertragung des logischen Pegels vom Ausgang des Flipflops $P_t$ zum Eingang des Flipflops PO zuläßt, für jedes der Flipflops der Anordnung P eine UND-Schaltung aufweist, deren einer Eingang mit dem Ausgang $QP_b$ des entsprechenden Flipflops $P_b$ verbunden ist, wobei b zwischen 1 und N liegt, wobei die anderen Eingänge dieser Schaltung mit den entsprechenden Ausgängen $QP_{b-1}$ und $QP_{b-2}$ der Flipflops $P_{b-1}$ und $P_{b-2}$ der Anordnung P und mit dem Ausgang $QF_b$ des Flipflops $F_b$ vom gleichen Rang des Registers F verbunden sind, der logische Pegel am Ausgang des Flipflops $P_t$ dem Eingang des Flipflops PO nur dann übermittelt wird, wenn der entsprechende Ausgang $QF_b$ des Registers F den Pegel 1 hat und wenn $QP_b=1$, $QP_{b-1}=1$ und $QP_{b-2}=0$ sind, die Einrichtungen V weiterhin eine ODER-Schaltung aufweisen, deren Eingänge mit den Ausgängen der UND-Schaltungen verbunden sind, der Ausgang dieser ODER-Schaltung dem Flipflop PO die einzige Information überträgt, die dem logischen Pegel des Ausgangs des Flipflops $P_t$ entspricht und die in Übereinstimmung mit dem 1/0-Übergang der logischen Pegel an den Ausgängen des Registers F detektiert worden ist, die Einrichtungen U, die die Verschiebungsfolge hervorrufen, weiterhin Einrichtungen W enthalten, die mit der Einrichtung V und mit den Schiebesteuereingängen der Flipflops der Speicheranordnung P und mit den Ausgängen des Schieberegisters F verbunden sind, um den Schiebebetrieb zwischen den Flipflops der Anordnung P zu steuern, und eine Steuereinrichtung X einerseits mit den Steuereinrichtungen W für die Verschiebung zwischen den Flipflops der Anordnung P und andererseits mit dem Ausgang QPO des Flipflops PO verbunden ist, wobei die Einrichtung X es erlaubt, entweder den Markierungsgrenzwert t der Einrichtung R zum Markieren und Initialisieren zu reinitialisieren oder den Rang dieses Grenzwertes um eine Einheit zu erhöhen.

8. Generator nach einem der Ansrpüche 6 und 7, dadurch gekennzeichnet, daß die Einrichtungen W zum Steuern der Verschiebungen von einem logischen Kreis gebildet sind, der mittels der Eingabeeinrichtungen (CH) und der Steuereinrichtung (X) simultane Verschiebungen des Zustandes des Speichers PO auf den Speicher P1 und jedes Speichers Pj auf den nachfolgenden Speicher Pj+1 für alle Speicher Pj hervorruft, deren Rang zwischen 1 und t−1 liegt, wobei die Speicher Pk den Zustand bei allen Speichern Pk nicht ändern, deren Rang über t liegt, der Speicher PO mit dem Zustand des Speichers Pt vom Rang t im Laufe dieser Verschiebung geladen wird, die Steuereinrichtung X für die Markierungseinrichtung R durch logische Pegel, die einer an gewissen Speichern vorbestimmten Kombination entsprechen, die Verschiebungen zwischen den Flipflops des Registers F mittels der Eingabeeinrichtungen CH der Speicheranordnung P steuern, die Einrichtungen U, die eine Verschiebungsfolge zwischen den Flipflops der Anordnung P hervorrufen, weiterhin Einrichtungen Z aufweisen, die mit dem Speicher PO verbunden sind, um anzuzeigen, daß an den Ausgängen der Speicher der Anordnung P eine Kombination vorhanden ist oder um den Start von Suchoperationen nach einer anderen Kombination zu befehlen, wobei die Einrichtungen Z zum Anzeigen und zum Befehlen des Starts weiterhin mit dem Ausgang eines Befehlstaktgebers H für die unterschiedlichen Verschiebeoperationen und mit dem Ausgang QPO des Flipflops PO verbunden sind, um die Anwesenheit des logischen Pegels 0 am Ausgang QPO so zu markieren, daß der Taktgeber angehalten wird und um die Anwesenheit einer an p Ausgängen der Anordnung P zur Verfügung stehenden Kombination anzuzeigen oder um den Taktgeber wieder zu starten für die Suche nach einer anderen Kombination, wobei dieser Taktgeber die Verschiebeoperationen mittels Einrichtungen A zum Unterbrechen der Erzeugung von Kombinationen, Steuereinrichtungen X und Einrichtungen C zum Laden der Flipflops der Anordnung P steuert, die Einrichtungen A zum Unterbrechen der Erzeugung von Kombinationen einen Zähler CPPO enthälten, der von den Eingabeeinrichtungen (CH) mit dem Wert N−1 bei der Initialisierung des Ranges t, der durch die Einrichtungen R zum Initialisieren und Markieren bestimmt ist, geladen ist und bei jeder Erhöhung des Ranges t um eine Einheit aktiviert wird, um die Verschiebeoperationen anzuhalten, wenn sein Inhalt 0 erreicht, wobei die Zähleinrichtung weiterhin eine UND-Schaltung aufweist, die mit dem Ausgang des Zählers und mit dem Ausgang des Taktgebers verbunden ist und deren Ausgang die Verschiebeoperationen mittels der Steuereinrichtungen X und der Eingabeeinrichtungen CH für die Flipflops der Anordnung P steuert.

9. Generator nach einem der Ansprüche 6 bis 8, dadurch gekennzeichnet, daß die Register F der Einrichtungen R, die Flipflops der Anordnung P, die Einrichtungen V zum Übermitteln des Zustands des Flipflops $P_t$ an das Flipflop PO ein Modul bilden, der Generator eine Vielzahl dieser Module aufweist, die in Kaskade so geschaltet sind, daß der Ausgang des letzten Flipflops einer Anordnung P eines Moduls mit dem Eingang des ersten Flipflops der Anordnung P des folgenden Moduls verbunden ist, der Ausgang des letzten Flipflops der Markierungseinrichtungen R eines Moduls mit dem Eingang des ersten Flipflops der Markierungseinrichtung des folgenden Moduls verbunden ist, jeder Ausgang der ODER-Schaltungen der Einrichtungen V zum Übertragen des logischen Pegels vom Ausgang des Flipflops $P_t$ auf den Eingang des Flipflops PO mit diesem Eingang über einen Transistor verbunden ist, der mit "offenem Kollektor" geschatet ist, der Ausgang QPO des Flipflops PO mit dem Eingang des ersten Flipflops der Anordnung P des ersten Moduls verbunden ist, die Flipflops der Speicher der Anordnung P der Module und die Flipflops der Einrichtungen R zum Markieren und Initialisieren der Module mit den Eingabeeinrichtungen (CH) verbunden sind.

10. Generator nach Anspruch 9, dadurch gekennzeichnet, daß er weiterhin einen logischen Kreis (ET17, OU7) zum Unterbrechen der Erzeugung von Kombinationen von einer vorbestimmten Kombination an enthält, der Eingänge aufweist, die mit den Ausgängen der Speicher (P) verbunden sind, die den Ausgängen entsprechen, die die genannte vorbestimmte Kombination liefern, und einen Steuerausgang für die Blockierung des Taktgenerators (H) aufweist.

11. Generator nach einem der Ansprüche 1 und 2, dadurch gekennzeichnet, daß zum Bilden der Kombinationen aus p=2 Ausgängen des logischen Pegels 1 und aus N−p Ausgängen des logischen Pegels 0 unter den N Ausgängen (QP1...QPN) des Generators die Anordnung P der N Speicher ($P_1...P_N$) eine Gruppe von zwei Schieberegistern (J, K) aufweist, die entsprechend aus N−1 Flipflops (J1,...JN−1, K2,...KN) gebildet sind, wobei die Ausgänge (QJ1...QJN−1) des ersten Registers J mit 1 bis N−1 markiert sind und die Ausgänge (QK2...QKN) des zweiten Registers K mit 2 bis N markiert sind, der erste Ausgang (QP1) der Speicheranordnung P vom Ausgang QJ1 des ersten Flipflops (J1) des ersten Registers J und der letzte Ausgang (QPN) der Speicheranordnung P vom Ausgang (QKN) des letzten Flipflops (KN) des zweiten Registers (K) gebildet sind, die Speicheranordnung (P) weiterhin eine Anordnung (E) aus N−2 ODER-Schaltungen mit zwei Eingängen aufweist, wobei die beiden Eingänge dieser ODER-Schaltungen entsprechend mit den Ausgängen (QJ2, QK2, QJ3, QK3...QJN−1, QKN−1) der entsprechenden Flipflops gleichen Ranges (J2, K2, J3, K3...JN−1, KN−1) der Register (J, K) verbunden sind, die Ausgänge dieser ODER-Schaltungen die entsprechenden Ausgänge (QP2...QPN−1) der Speicheranordnung P sind, die Eingabeeinrichtungen (CH) die Initialisierungssignale, die Nullstellsignale und die Verschiebungssignale an die entsprechenden Eingänge der Register (J, K) anlegen und die Steuereinrichtungen (M) mit den Ausgängen der Schieberegister (J, K) verbunden sind, um die Erzeugung der Kombinationen mittels der Eingabeeinrichtungen (CH) und der

Unterbrechungseinrichtungen (A) zu steuern, wobei die Einrichtung M Einrichtungen (D) aufweist, deren Eingänge entsprechend mit den Ausgängen der Schieberegister (J, K) verbunden sind, um festzustellen, ob ein Flipflop vom Rang j des ersten Registers (J) und ein Flipflop vom Rang K=j+1 des zweiten Registers (K) einen Pegel 1 aufweisen, wobei j zwischen 1 und N−1 und K zwischen 2 und N variieren kann, daß Steuereinrichtungen (X) vorgesehen sind, deren einer Steuereingang mit einem Ausgang der Detektoreinrichtungen (D) verbunden ist und deren Ausgänge mit den Steuereingängen der Eingabeeinrichtungen (CH) verbunden sind, um eine Triggerung zu bewirken, sei es eine Verschiebung des im ersten Register (J) enthaltenen Rangs, wenn die Detektoreinrichtungen (D) keine zwei aufeinanderfolgenden Pegel 1 an den aufeinanderfolgenden Ausgängen der Ränge j und k der zwei Flipflops der beiden Register (J, K) festgestellt haben, sei es eine Verschiebung des Ranges des Inhalts des zweiten Registers K und ein Reinitialisierung des Inhalts des ersten Registers (J) derart, daß der Ausgang (QJ1) des ersten Flipflops (J1) des ersten Registers (J) den Pegel 1 annimmt und die anderen Ausgänge (QJ2...QJN−1) der Ränge 2 bis N−1 dieses ersten Registers (J) den Pegel 0 annehmen, Einrichtungen (Z) aufweist, um anzuzeigen, daß eine Kombination an den Ausgängen (QP1...QPN) der Speicheranordnung (P) vorhanden ist oder um die Suche nach einer anderen Kombination zu befehlen, und die an ihren Eingängen Initialisierungssignale, Freigabesignale oder Suchbefehle nach einer anderen Kombination erhält und einen Ausgang aufweist, der ein Signal abgibt, das die Anwesenheit einer Kombination an den Ausgängen der Speicheranordnung (P) anzeigt, und einen weiteren Ausgang aufweist, von mit einem Eingang eines Freigabekreises (VA) für die von den Eingabeeinrichtungen ausgeführten Operationen auf Impulse einer Taktquelle (H) hin verbunden ist, deren Ausgang mit einem weiteren Eingang des Freigabekreises verbunden ist, daß Unterbrechungseinrichtungen (A) vorhanden sind, die einen Ausgang aufweisen, der mit einem weiteren Eingang des Freigabekreises (VA) verbunden ist, um diesen zu sperren, wenn die gewünschten Kombinationen erhalten worden sind und die an ihren Eingängen Nullsetzsignals und Verschiebesteuersignale empfängt, die am ersten Register (J) anliegen, daß die Detektoreinrichtungen (D) von N−1 UND-Schaltungen mit zwei Eingängen gebildet sind, die mit 1 bis N−1 markiert sind, wobei die Eingänge einer jeden Schaltung entsprechend mit einem Ausgang des Flipflops des gleichen Rangs des Registers J und dem Ausgang des Flipflops des unmittelbar darüberliegenden Ranges des Registers K verbunden sind und die Ausgänge dieser UND-Schaltungen mit den Eingängen einer ODER-Schaltung verbunden sind, deren Ausgang mit dem Befehlseingang der Steuereinrichtungen verbunden ist, daß die Unterbrechungseinrichtungen (A) von einem Zähler gebildet sind, der auf einen Wert N−2 bei jeder Initialisierung des ersten Registers (J) geladen wird, und daß dieser Zähler bei jeder Verschiebung des Inhalts des ersten Registers (J) um eine Einheit abwärts zählt.

12. Generator nach Anspruch 11, dadurch gekennzeichnet, daß er weiterhin einen logischen Kreis zum Unterbrechen der Erzeugung von Kombinationen von einer vorbestimmten Kombination an enthält, der Eingänge aufweist, die mit den Ausgängen der Speicheranordnung (P) entsprechend den Ausgängen verbunden sind, die die genannte vorbestimmte Kombination liefern, und einen Steuerausgang zur Blockierung des Taktgebers (H) aufweist.

13. Generator nach Anspruch 12, dadurch gekennzeichnet, daß er eine Vielzahl von Gruppen von Schieberegistern (J, K) aufweist, die in Serie geschaltet sind, eine Vielzahl von ODER-Schaltungsanordnungen mit zwei Eingängen aufweist, die entsprechend den Schieberegistergruppen (J und K) zugeordnet sind, und eine Vielzahl von Detektoreinrichtungen (D), die entsprechend den Schieberegistergruppen (J, K) zugeordnet sind, wobei eine Registergruppe (J, K) sowie die Detektoreinrichtungen (D) und die ODER-Schaltungsanordnung, die dieser Gruppe entsprechen, ein Modul bilden, die Ausgänge der ODER-Schaltungsanordnungen der Detektoreinrichtungen (D) mit dem Steuereingang (C) der Steuereinrichtungen (X) über einen Transistor mit offenem Kollektor verbunden sind.

**Claims**

1. Generator of combined logic signals to form combinations at p outputs at logic level 1 and N−p outputs at logic level 0 between N outputs (QP1,...QPN) of the generator amongst which are available the p logic signals of level 1 and the N−p logic signals of level 0, N and p being constants, characterized in that it comprises:

— an assembly (P) of N memory means (P1, P2,...PN), said memory means being distributed from row 1 to row N, the combinations of p outputs at level 1 and N−p outputs at level 0 being supplied at outputs (QP1,...QPN) of the memory means of rows 1 to N;
— means (CH) for loading the memory means (P1, P2,...PN), with logic levels corresponding to a predetermined starting combination;
— command means (M) to register the memory means Pi which is defined as being a means whose output is at logic level 1 and which is immediately followed by memory means $P_{i+1}$ whose output is at logic level 0, the row i being the lowest possible, means M enabling restoration, at all memory means which precede the means $P_i$, a succession of logic levels 1, starting with the memory means of row 1 up to the means of row n inclusive, n being equal to the number of levels 1 existing in the memory means preceding the means $P_i$ succession

being completed by levels 0 after the memory means of the row n and before the means of row i, the command means (M) also permitting replacing the state of memory means Pi by a level 0 and the state of memory means Pi+1 by level 1, the memory means of the row after i+1 not changing its state, repeated application of the command means M providing the combinations which succeed the predetermined starting combination; and
— means (A) for stopping generation of combinations after another predetermined combination.

2. Generator according to Claim 1, characterized in that said predetermined starting combination is either the first combination for which the logic levels 1 are available at the outputs of the first P memory means ($P_1$, $P_2$,...$P_p$), the outputs of N−p memory means following ($P_{p+1}$, $P_{p+2}$...$P_N$) being at logic level 0, or any other predetermined combination of logic levels 1 available at the outputs of p memory means.

3. Combination generator according to Claim 2, characterized in that the command means (M) comprise:

— means R for registering the row t of a certain memory means Pt and developing the row t, said means R being connected to loading means CH to initialise t to a value such that the corresponding memory means Pt is that which follows the first memory means whose output is at logic level 1, when the combination is available at outputs QP1 to QPN;
— a memory means PO whose output is QPO;
— means U to produce a succession of one or more shift operations between the memory means of the assembly (P), until the state at the output QPO of the memory means PO is at level 0, each operation producing simultaneous shifts of the state cf memory means PO, towards the memory means P1 and of each of the means Pj of the row j, towards the following means Pj+1 of row j+1, for all the means Pj whose row is included between 1 and t−1, the means Pk of row k not changing state for all the memory means Pk of row k greater than t, the memory means PO being loaded by the state of the output of means Pt of row t, in the course of said shift operation, each operation also producing either reinitialisation of the limit t of the registering and initialising means (R) to the condition such that the output of the memory means (Pt), is either at level 0 at the same time as the state of means PO is at level 1, or increasing by one unit of the row t corresponding to the registering limit of means (R) if said latter condition is not satisfied, said evolution of row t being conditioned by the state of the output of means PO and Pt before shift, the new row t only being operative after shift, the application of means U providing successive combinations whose presence is determined by level 0 at the output of flip-flop QPO, the means U comprising a means V permitting reporting of the state of flip-flop Pt towards the input of flip-flop PO, the means (R) for registering, initialising and evolving row t, being constituted by a shift register (F), having N+1 flip-flops numbered 1 to N+1, said register being loaded by t levels 1 at the t first flip-flops and by N−t+1 levels 0 at the following flip-flops, the N+1 outputs (QF1, QF2,...QFN+1) of the register F serving to validate or invalidate the shifts and to select the flip-flop Pt detecting the transition 1,0 at register F to report the state of the flip-flop Pt towards the means PO, QF1 validating the transfer between PO and P1, QF2 validating the transfer between P1 and P2,...$Q_{FN}$ validating the transfer between $P_{N-1}$ and $P_N$ and QFN+1 detecting the transition 1,0 whatever the value of N.

4. Generator according to Claim 3, characterized in that the memory means ($P_1$, $P_2$...$P_N$) of the assembly P comprises a single shift register with N flip-flops.

5. Generator according to Claim 3, characterized in that the means (R) for registration and initialisation additionally comprise means for initialising F such that t=2.

6. Generator according to Claim 5, characterized in that the means V permitting reporting the state of flip-flop Pt towards the input of flip-flop PO, comprise, for each flip-flop of the assembly P, an AND gate one input of which is connected to the output $QP_b$ of the corresponding flip-flop Pb, for b between 1 and N, the other inputs of said gate being respectively connected to the output $QF_b$ of the same row of the flip-flop $F_b$ of register F and to the output $QF_{b+1}$ of the flip-flop Fb+1, of the row immediately preceding, the logic level of the output of flip-flop $P_t$ only being reported to the input of flip-flop PO if the corresponding output $QF_b$ of register F is at level 1 and if the output $QF_{b+1}$ of the directly preceding row is at level O, the means V additionally comprising an OR gate whose inputs are connected to the outputs of the AND gates, the output of said OR gate transmitting to flip-flop PO, the only information corresponding to the logic level of the output of flip-flop $P_t$ which was detected by transition of levels, 1,0 on the logic levels at the outputs of register F, the means U which produce the succession of shifts additionally comprising means W connected to shift command inputs of the flip-flops of memory assembly P and to the shift registering outputs F connected themselves to means V, to command shift operations between the flip-flops of the assembly P, and a control means X connected on the one hand to command means W for shift operations between the flip-flops of assembly P, and on the other hand, to the output QPO of the flip-flop PO, said means X enabling either reinitialisation of the registration limit t of the means R for registering and initialisation, or increase by one unit of the row of said limit.

7. Generator according to Claim 5, characterized in that the means V permitting reporting of the logic level of the output of flip-flop Pt towards the input of flip-flop PO, comprises, for each flip-flop of the assembly P, an AND gate one of whose inputs is connected to the output $QP_b$ of the corresponding flip-flop $P_b$, where b is between 1 and N, the other inputs of said gate being respectively connected to the outputs $QP_{b-1}$ and $QP_{b-2}$ of flip-flops $P_{b-1}$ and $P_{b-2}$ of the assembly P and to the output $QF_b$ of the flip-flop $F_b$ of the same row of register F, the logic level at the output of flip-flop $P_t$ not being reported to the input of flip-flop PO unless the corresponding output $QF_b$ of the register F is at the level 1 and unless $QP_b=1$, $QP_{b-1}=1$ and $QP_{b-2}=0$, the means V additionally comprising an OR gate whose inputs are connected to the outputs of the AND gates, the output of said OR gate transmitting to flip-flop PO the only information corresponding to the logic level at the output of flip-flop $P_t$ and which has been detected in correspondence with the transition 1,0 of the logic levels at the outputs of register F, the means U which produce the succession of shifts additionally comprising means W connected to means V and to shift command inputs of the flip-flops of the memory assembly P and to the outputs of the shift register F, to command shift operations between the flip-flops of assembly P, and a control means X connected on the one hand to means W for commanding shift operations between the flip-flops of assembly P and on the other hand, to the output QPO of the flip-flop PO, said means X enabling either reinitialisation of the registration limit t of the registration and initialisation means R, or increase by one unit in the row of said limit.

8. Generator according to either of Claims 6 and 7, characterized in that the shift command means W comprise a logic circuit producing, through loading means (CH) and the control means (X) simultaneous shifts of the state of the memory means PO to means P1 and of each of the means Pj towards the following means Pj+1 for all the means Pj whose row is included between 1 and t−1, the means Pk not changing the state for all the memory means Pk of the row after t, the memory means PO being loaded by the state of means Pt or row t in the course of said shift operation, the control means X of the registration means R, commanding, through logic levels corresponding to a predetermined combination of certain memory means, shifts between the flip-flops of register F through the intermediary of the loading means CH of memory means P, the means U which produce a succession of shift operations between the flip-flops of assembly P additionally comprising means Z connected to memory means PO to indicate that a combination is produced at the outputs of memory means of the assembly P or to command release of search operations for another combination, said means Z for indication and release-command additionally being connected to the output of a clock H commanding different shift operations and to the output QPO of the flip-flop PO to register the presence of logic level O at the output QPO, whereby to stop the clock and indicate presence of an available combination at p outputs of the assembly P, or to re-release the clock to search for another combination, said clock commanding shift operations through the intermediary of means A for stopping generation of combinations, control means X and means C for loading the flip-flops of assembly P, the means A for stopping generation of combinations comprising a counter CPPO loaded to value N−1 by the loading means (CH), in the initialisation of row t determined by the initialisation and registration means R, said counter being activated at each increase by one unit of row t, whereby the shift operations are stopped when its content reaches 0, said counting means additionally comprising an AND gate connected to the output of the counter and the output of the clock, the output of said gate commanding the shift operations through control means X and means CH for loading the flip-flops of the assembly P.

9. Generator according to any of Claims 6 to 8, characterized in that the registers F of means R, the flip-flops of assembly P, and the means V for reporting the state of flip-flop $P_t$ to the flip-flop PO, form a module, the generator comprising a plurality of said modules connected in cascade whereby the output of the last flip-flop of an assembly P of a module is connected to the input of the first flip-flop of the assembly P of a following module, the output of the last flip-flop of the registration means R of a module being connected to the input of a first flip-flop of the registration means of the following module, each output of the OR gates of means V for reporting the logic level of the output of flip-flop $P_t$ towards the input of the flip-flop PO, being connected to said input through a transistor mounted in "collector open" mode, the output QPO of the flip-flop PO being connected to the input of the first flip-flop of assembly P of the first module, the flip-flops of the memory means of the assemblies P of the modules and the flip-flops of the means R for registration and initialisation of the modules being connected to the loading means (CH).

10. Generator according to Claim 9, characterized to that it additionally comprises a logic circuit (AND 17, OR7) for blocking generation of combinations, from a predetermined combination, said logic circuit having inlets connected to the outputs of the memory means (P) which correspond to the outputs providing said predetermined combination, and an output commanding blockage of the clock (H).

11. Generator according to either of Claims 1 and 2, characterized in that, to form combinations at p=2 outputs of logic levels 1 and N−p outputs at logic level 0, among the N outputs (QP1...QPN) of the generator the assembly P of N memory means $(P_1...P_N)$ comprises a group of two shift registers (J, K) respectively constituted by N−1 flip-flops (J1...JN−1, K2,...KN), the outputs (QJ1...QJN−1) of the first register J being registered from 1 to N−1 and the outputs (QK2...QKN) of the second register K being registered from 2 to N, the first output (QP1) of the memory means P comprising the output (QJ1) of the first flip-flop (J1) of the first register (J) and the last output (QPN) of the memory means (P) comprising the output (QKN) of the last flip-flop (KN) of the second register (K), the memory assembly (P) additionally comprising an assembly (E) with N−2 OR gates having two inputs, the two inputs of said OR gates being respectively connected to the corresponding outputs (QJ2, QK2, QJ3, QK3...QJN−1, QKN−1) of the flip-flops of the same row (J2, K2, J3, K3...JN−1, KN−1) of the registers (J, K), the outputs of said OR gates respectively constituting the outputs (QP2...QPN−1) of the memory means P, the loading means (CH) applying signals of initialisation, resetting to 0 and shifting at the corresponding inputs of registers (J, K) and the command means (M) being connected to the outputs of shift registers (J, K) to command generation of combinations, through the intermediary of loading means (CH) and stopping means (A), the means M comprising means (D) whose inputs are respectively connected to the outputs of the shift registers (J, K) to detect if a flip-flop of the row j of the first register (J) and a flip-flop of the row K=j+1 of the second register (K) are at a level 1, j being variable from 1 to N−1 and K from 2 to N, control means (X) of which one command entry is connected to the output of detection means (D) and whose outputs are connected to the command inputs of loading means (CH) to release either a shift of a row of the contents of the first register (J) if the detection means (D) have not detected two successive levels 1 on the outputs of successive rows j and k of two flip-flops of the two registers (J, K), or a shift of a row contained in the second register (K) and reinitialisation of the contents of first register (J) so that the output (QJ1) of the first flip-flop (J1) of the first register (J) has a level 1 and the other outputs (QJ2...QJN−1) of rows 2 to N−1 of the first register (J) are at level 0, means (Z) to indicate if a combination is presented at the outputs (QP1...QPN) of the memory means (P) or to command search for another combination, said means (Z) for indicating and commanding search for a combination receiving, at its inputs, signals of initialisation, validation or command for search for another combination, an output of said means providing a signal indicating the presence of a combination at the outputs of the memory means (P), another output of said means being connected to an input of a validation circuit (VA) for operations carried out by the loading means (CH) from pulses of a clock (H) whose output is connected to another input of the validation means (VA), the stopping means (A) having an output which is connected to another input of the validation means (VA) to block the validation means when the desired combinations have been obtained, said stopping means (A) receiving at its inputs, the signals for resetting to zero and shift command, supplied to the first register (J), detection means (D) comprising N−1 AND gates having two inputs, said gates respectively being registered from 1 to N−1, the inputs of each gate being respectively connected to the output of the flip-flop of the same row of register (J) and to the output of the flip-flop of the row immediately after in register (K), the outputs of said AND gates being connected to the inputs of an OR gate whose output is connected to the command input of the control means (X), the means for stopping (A) being constituted by a counter loaded to a value N−2 at each initialisation of the first register (J), said counter counting down by one unit at each shift of the contents of the first register (J).

12. Generator according to Claim 11, characterized in that it additionally comprises a logic circuit for blocking generation of combinations, starting from a predetermined combination, said logic circuit having inputs connected to the outputs of memory means (P) corresponding to outputs providing said predetermined combination, and an output commanding blocking of the clock (H).

13. Generator according to Claim 12, characterized in that it comprises a plurality of groups of shift registers (J, K) connected in series, a plurality of assemblies of OR gates having two inputs, respectively associated with the groups of shift registers (J, K), and a plurality of detection means (D), respectively associated with the groups of shift registers (J, K), a group of the registers (J, K) as well as detection means (D) and the assembly of OR gates which corresponds to that group forming a module, the outputs of the assemblies of (OR) gates of the detection means (D) being connected to the command input (C) of the control means (X) through a transistor mounted in the "open collector" mode.

FIG. 1A

0 058 108

FIG. 1B

|  |  | $QP_1$ | $QP_2$ | $QP_3$ | $QP_4$ | $QP_5$ |
|---|---|---|---|---|---|---|
| $i = 3$ | $n = 2$ | 1 | 1 | 1 | 0 | 0 |
| $i = 2$ | $n = 1$ | 1 | 1 | 0 | 1 | 0 |
| $i = 1$ | $n = 0$ | 1 | 0 | 1 | 1 | 0 |
| $i = 4$ | $n = 2$ | 0 | 1 | 1 | 1 | 0 |
| $i = 2$ | $n = 1$ | 1 | 1 | 0 | 0 | 1 |
| $i = 1$ | $n = 0$ | 1 | 0 | 1 | 0 | 1 |
| $i = 3$ | $n = 1$ | 0 | 1 | 1 | 0 | 1 |
| $i = 1$ | $n = 0$ | 1 | 0 | 0 | 1 | 1 |
| $i = 2$ | $n = 0$ | 0 | 1 | 0 | 1 | 1 |
|  |  | 0 | 0 | 1 | 1 | 1 |

## FIG. 2

|  | $QP_0$ | $QP_1$ | $QP_2$ | $QP_3$ | $QP_4$ | $QP_5$ |
|---|---|---|---|---|---|---|
| $t = 2$ | 0 | 1 | 1 | 1 | 0 | 0 |
| $t = 3$ | 1 | 0 | 1 | 1 | 0 | 0 |
| $t = 4$ | 1 | 1 | 0 | 1 | 0 | 0 |
| $t = 2$ | 0 | 1 | 1 | 0 | 1 | 0 |

## FIG. 3

3

| | | $QP_0$ | $QP_1$ | $QP_2$ | $QP_3$ | $QP_4$ | $QP_5$ | CPPO |
|---|---|---|---|---|---|---|---|---|
| A | RAZ P INIT | 1 | 0 | 0 | 0 | 0 | 0 | |
| | RAZ F INIT | 1 | 0 | 0 | 0 | 0 | 0 | 4 |
| | p. CP INIT | 1 | 1 | 1 | 1 | 0 | 0 | 1 |
| | RAZ F INIT | 1 | 1 | 1 | 1 | 0 | 0 | 4 |
| | RAZ $QP_0$ | 0 | 1 | 1 | 1 | 0 | 0 | 4 |
| B | CP CF | 1 | 0 | 1 | 1 | 0 | 0 | 3 |
| | CP CF | 1 | 1 | 0 | 1 | 0 | 0 | 2 |
| | CP RAZ F | 0 | 1 | 1 | 0 | 1 | 0 | 4 |
| C | CP CF | 1 | 0 | 1 | 0 | 1 | 0 | 3 |
| | CP RAZ F | 0 | 1 | 0 | 1 | 1 | 0 | 4 |
| D | CP CF | 0 | 0 | 1 | 1 | 1 | 0 | 3 |
| E | CP CF | 1 | 0 | 0 | 1 | 1 | 0 | 2 |
| | CP CF | 1 | 1 | 0 | 0 | 1 | 0 | 1 |
| | CP RAZ F | 0 | 1 | 1 | 0 | 0 | 1 | 4 |
| F | CP CF | 1 | 0 | 1 | 0 | 0 | 1 | 3 |
| | CP RAZ F | 0 | 1 | 0 | 1 | 0 | 1 | 4 |
| G | CP CF | 0 | 0 | 1 | 1 | 0 | 1 | 3 |
| H | CP CF | 1 | 0 | 0 | 1 | 0 | 1 | 2 |
| | CP CF | 0 | 1 | 0 | 0 | 1 | 1 | 4 |
| I | CP CF | 0 | 0 | 1 | 0 | 1 | 1 | 3 |
| J | CP CF | 0 | 0 | 0 | 1 | 1 | 1 | 2 |
| K | CP CF | 1 | 0 | 0 | 0 | 1 | 1 | 1 |
| | CP CF | 1 | 1 | 0 | 0 | 0 | 1 | 0 |
| | FIN d'ORDRE | | | | | | | |

## FIG. 4

FIG. 5

CHARGEMENT PREMIERE COMBINAISON ET INITIAL. DU SYSTÈME

$\overline{COMPT}.\ QP_0$

= 1

= 0

CP
RAZ. F
CPPO = N_1

CP
CF
CPPO = CPPO_1

≠ 0

CPPO

= 0  Fin

$QP_0$

= 1

= 0

EXPLOITER COMBINAISON PRESENTEE SUR SORTIES REGISTRE P

RECHERCHE COMBINAISON SUIVANTE

FIG. 6

FIG. 7A

FIG. 7B

|  |  | $QP_1$ | $QP_2$ | $QP_3$ | $QP_4$ | $QP_5$ |
|---|---|---|---|---|---|---|
| $i=2$ | $n=1$ | 1 | 1 | 0 | 0 | 0 |
| $i=1$ | $n=0$ | 1 | 0 | 1 | 0 | 0 |
| $i=3$ | $n=1$ | 0 | 1 | 1 | 0 | 0 |
| $i=1$ | $n=0$ | 1 | 0 | 0 | 1 | 0 |
| $i=2$ | $n=0$ | 0 | 1 | 0 | 1 | 0 |
| $i=4$ | $n=1$ | 0 | 0 | 1 | 1 | 0 |
| $i=1$ | $n=0$ | 1 | 0 | 0 | 0 | 1 |
| $i=2$ | $n=0$ | 0 | 1 | 0 | 0 | 1 |
| $i=3$ | $n=0$ | 0 | 0 | 1 | 0 | 1 |
|  |  | 0 | 0 | 0 | 1 | 1 |

# FIG. 8